(19) **Europäisches Patentamt / European Patent Office / Office européen des brevets**

(11) **EP 1 374 276 B1**

(12) **FASCICULE DE BREVET EUROPEEN**

(45) Date de publication et mention
de la délivrance du brevet:
**12.09.2007 Bulletin 2007/37**

(51) Int Cl.:
***H01J 37/32*** *(2006.01)*

(21) Numéro de dépôt: **02708589.3**

(86) Numéro de dépôt international:
**PCT/IB2002/001001**

(22) Date de dépôt: **26.03.2002**

(87) Numéro de publication internationale:
**WO 2002/076511 (03.10.2002 Gazette 2002/40)**

(54) **PROCEDE DE TRAITEMENT DE SURFACE PAR PLASMA ET DISPOSITIF POUR LA MISE EN OEUVRE DU PROCEDE**

VERFAHREN UND VORRICHTUNG ZUR PLASMABEHANDLUNG VON OBERFLÄCHEN

PLASMA SURFACE TREATMENT METHOD AND DEVICE FOR CARRYING OUT SAID METHOD

(84) Etats contractants désignés:
**AT BE CH CY DE DK ES FI FR GB GR IE IT LI LU MC NL PT SE TR**

(30) Priorité: **27.03.2001 EP 01810318**
**31.08.2001 EP 01120974**
**20.09.2001 EP 01810915**

(43) Date de publication de la demande:
**02.01.2004 Bulletin 2004/01**

(73) Titulaire: **Apit Corp. SA**
**1950 Sion (CH)**

(72) Inventeurs:
- **KOULIK, Pavel**
  **F-67113 Blaesheim (FR)**
- **SAMSONOV, Mickhail**
  **F-67400 Illkirch-Graffenstaden (FR)**
- **CHEREPANOV, Alexander**
  **F-67400 Illkirch-Graffenstaden (FR)**
- **PETROV, Evguenii**
  **F-67400 Illkirch-Graffenstaden (FR)**

(74) Mandataire: **Reuteler, Raymond Werner**
**WILLIAM BLANC & CIE,**
**Conseils en Propriété Industrielle SA,**
**25, Avenue du Pailly**
**1220 Les Avanchets/Genève (CH)**

(56) Documents cités:
**WO-A-99/46964          DE-A- 4 128 779**
**DE-C- 3 900 768         US-A- 5 569 502**

- **DATABASE WPI Section Ch, Week 9407 Derwent Publications Ltd., London, GB; Class M22, AN 1994-054827 XP002226209 & RU 2 000 890 C (KRAI PRODN TRADING ASSOC), 15 October 1993 (1993-10-15)**
- **PATENT ABSTRACTS OF JAPAN vol. 1996, no. 07, 31 July 1996 (1996-07-31) & JP 08 078745 A (SONY CORP), 22 March 1996 (1996-03-22)**
- **PATENT ABSTRACTS OF JAPAN vol. 013, no. 352 (E-801), 8 August 1989 (1989-08-08) & JP 01 111333 A (OKI ELECTRIC IND CO LTD), 28 April 1989 (1989-04-28)**

**Description**

La présente invention concerne un procédé de traitement de surface par plasma et un dispositif pour la mise en oeuvre du procédé. Le traitement peut être le dépôt d'un film ou de plusieurs films minces, le dépôt d'un film-barrière, la stérilisation, le nettoyage, le décapage, ou la création d'un alliage superficiel.

Dans l'état actuel de la technique, des dépôts de plasma sous vide et des dépôts de plasma à pression atmosphérique sont proposés. Les techniques sous vide permettent de traiter uniformément les surfaces complexes, telles que la surface intérieure d'une bouteille PET, mais elles sont lentes et relativement coûteuses vu la nécessité de créer et de travailler dans une chambre à vide. L'équipement correspondant est complexe, extrêmement cher et difficilement adaptable à différents types de récipients. L'exigence pour l'équipement d'être parfaitement hermétique est très difficile à assurer et se répercute sur la fiabilité du procédé et la constance des résultats.

Des procédés utilisant des plasmas à pression atmosphérique, ont été discutés dans plusieurs publications telles que le brevet GB 1,098,693, la demande de brevet WO 97/22369 et la demande de brevet WO 99/46964.

Les documents US 5,569,502, DE 4 128 779, DE 39 00 798 et JP 08078745 décrivent des procédés de traitement de surface d'un substrat par plasma, dans lesquels la surface du substrat est excitée au moyen des vibrations ultrasoniques générées par une source externe.

Dans le brevet GB 1,098,693 on décrit un dispositif de traitement de surface intérieure d'une bouteille en plastique pour la stérilisation de cette surface. Le dispositif comporte une électrode centrale introduite, dans la bouteille, et une électrode extérieure entourant la bouteille, formant un système coaxial connecté à une source de courant à haute fréquence. De l'argon (Ar) est introduit dans la bouteille par un orifice dans l'électrode centrale pour réduire le potentiel électrique nécessaire à la création du plasma. Le dispositif décrit dans ce brevet est caractérisé par un champ électrique élevé de l'ordre de 450 V/cm et un courant très faible de l'ordre de quelques milliampères. Le temps de traitement est trop long et la puissance trop faible pour que ce procédé soit industrialisable et puisse concourir avec les méthodes de plasma de vide.

Dans la demande de brevet WO 97/22369 consacrée à la stérilisation de récipients en matière plastique, on propose de former un plasma avec une source de courant RF dont l'amplitude de courant est élevée. On propose en outre de sortir l'électrode centrale de la bouteille, ce qui permet une cadence de stérilisation des bouteilles PET répondant aux besoins industriels. Un désavantage du procédé et du dispositif décrit dans cette demande est qu'ils ne permettent pas un traitement uniforme de la surface à traiter. On peut s'attendre à ce que le plasma ne recouvre qu'une partie de cette surface. Il s'ensuit une mauvaise stérilisation des surfaces qui n'ont pas été en contact avec le plasma. Pour les mêmes raisons, un tel procédé ne permettrait pas de créer une barrière uniforme sur toute la surface interne d'un récipient.

Dans la demande de brevet WO 99/46964, un procédé de traitement de surface est décrit dans lequel un cordon pulsé de plasma à pression atmosphérique est formé qui balaie la surface à traiter par un mouvement relatif de cette surface et du dispositif formant et confinant le cordon de plasma. On pourrait s'attendre à ce qu'un tel procédé permette le dépôt d'une couche par exemple imperméabilisante et une stérilisation uniforme de la surface à traiter, du fait que le cordon de plasma balaie toute la surface à traiter. En réalité, il s'avère être difficile d'obtenir un traitement de surface, et notamment le dépôt d'un film ou la stérilisation, de qualité satisfaisante.

En raison de l'échauffement local, il est nécessaire de déplacer la colonne de plasma par rapport à la surface à traiter. La vitesse, qui est dictée par la nécessité de ne pas surchauffer le matériau de la surface à traiter, est surélevée par rapport à la vitesse optimale de traitement pour beaucoup d'applications. Une des conséquences est qu'une couche limite de gaz froid entraîné par l'objet souffle la décharge et l'éloigne de la surface à traiter. Cet éloignement réduit le flux de diffusion des particules actives du plasma vers la surface à traiter. On peut partiellement résoudre ce problème en renouvelant la décharge par impulsions. Toutefois, la fréquence des impulsions est également dictée par la nécessité de ne pas surchauffer le matériau de la surface à traiter et ne peut donc pas être optimisée pour différentes applications.

Le volume du plasma créé par les procédés de traitement par plasma atmosphérique connus est important et entraîne un faible rendement du fait qu'une grande partie de l'énergie dépensée est perdue dans l'échauffement du gaz environnant et de l'objet traité. D'autre part, pour les applications de dépôt de film-barrières, de la poudre se forme dans le volume du cordon de plasma (par exemple de la poudre de $SiO_2$) et se dépose sur la surface à traiter. Cette poudre, n'ayant qu'une faible adhésion à la surface, représente un obstacle à la création d'un film de haute qualité.

Les désavantages et limitations des procédés de traitement par plasma connus ne se limitent pas à ce qui est décrit ci-dessus. Par exemple, pour des plasmas qui sont proches d'un état d'équilibre thermodynamique tel qu'il en résulterait du procédé décrit dans WO 99/46964, il est difficile d'effectuer un bombardement électronique de la surface à traiter puisque le parcours moyen des électrons ($\leq 10^{-4}$cm) par rapport aux interactions élastiques de la surface à traiter est généralement inférieur à l'épaisseur de la couche limite ($\geq 10^{-2}$ cm) du plasma. Il s'ensuit qu'il est difficile par un tel procédé d'adapter l'interface substrat-film en fonction de la qualité de traitement voulu, tel qu'en activant la surface à traiter avant le dépôt d'un film pour assurer une bonne adhésion. Il serait par conséquent également difficile de former des films à plusieurs couches de différente composition, chacune d'elle étant activée avant dépôt de la prochaine.

Malgré le déplacement relatif entre le plasma et l'objet à traiter des procédés connus, l'expérience montre que des surchauffes locales sont inévitables et provoquent des claquages qui créent des défauts et des destructions locales de la surface à traiter. Ce désavantage est particulièrement important dans certaines applications, comme expliqué à titre d'exemple ci-après.

Les matériaux polymérisables tels que le PET (Polyéthylterphtalate), le PE (Polyéthylène), le PP (Polypropylène) et autres, sont utilisé dans diverses industries pour des produits tels que les récipients pour boisson et nourriture, les flacons et tubes pharmaceutiques et de parfumerie, les réservoirs à essence, les récipients pour produits chimiques, et les tubes au néon pour les réclames nocturnes, notamment en raison du bas coût et poids de ces matériaux. Néanmoins, un des désavantages des matériaux polymériques est leur perméabilité aux gaz. La perméabilité des bouteilles PET utilisées dans l'industrie alimentaire, par exemple, permet à l'oxygène de diffuser à travers la paroi de la bouteille et d'oxyder les aliments ou boissons qui, de par ce fait, perdent progressivement leurs propriétés telles que leur saveur, odeur, couleur. Les boissons gazeuses, par contre, perdent leur gaz carbonique. La perméabilité excessive des récipients en matière plastique diminue le temps de conservation des aliments. La diffusion de gaz à travers les parois en matière plastique peut avoir des effets néfastes sur un grand nombre d'autres produits, tels que des produits pharmaceutiques, cosmétiques, d'hygiène et d'entretien ménager. Dans le cas de réservoirs à essence ou d'autres récipients contenant des produits chimiques, la perméabilité des matériaux plastiques permet à ces produits de s'infiltrer dans la matière plastique de sorte qu'elle ne peut plus être facilement recyclée et qu'elle peut représenter un danger d'incendie. La perméabilité du plastique fait que les tubes au néon en plastique ont une durée de vie trop courte pour qu'ils soient commercialisables.

Un autre problème des matériaux plastiques provient des molécules aromatiques, telles que l'acétaldéhyde, qui se forment dans le volume du matériau et qui diffusent par la suite vers la surface, se transmettant au liquide remplissant le récipient. De telles molécules altèrent le goût et l'odeur de la boisson ou de l'aliment.

Une solution consiste à revêtir la surface intérieure du récipient d'un film imperméable dit "barrière". Différentes compositions peuvent former des barrières sur des polymères, telles que le carbone, l'oxyde d'aluminium et l'oxyde de silicium ($SiO_2$). Le dépôt d'un film-barrière peut être effectué par du plasma en contact avec la surface et en présence d'un gaz fournissant les molécules formant la couche. Les matériaux plastiques mentionnés ci-dessus ne supportent toutefois pas des températures dépassant environ 60 à 70 degrés Celsius, de sorte à ce qu'il est difficile d'éviter des surchauffes locales ou d'obtenir une qualité de traitement suffisante avec les procédés de traitement par plasma connus. A titre d'exemple, les films-barrières déposés sur bouteilles PET par les procédés de traitement par plasma industriels conventionnels permettent d'obtenir une facteur relatif d'augmentation de la perméabilité (BIF) par rapport au matériau non traité de l'ordre de 20 à 30 pour l'oxygène respectivement 5 à 6 pour le $CO_2$. Les défauts caractéristiques de telles couches barrières sont un manque d'adhésion, de flexibilité, ou un apparition de fractures qui entraînent une perte d'imperméabilité. Ces défauts peuvent également représenter un danger pour le consommateur.

Il y a beaucoup d'autres matériaux qui ne supportent pas l'augmentation de température que nécessiterait l'optimisation du procédé de traitement de surface par plasma. C'est le cas, par exemple, des plaques de silicium utilisées dans l'industrie des semi-conducteurs. En effet, les structures semi-conductrices à la surface des circuits peuvent être altérées ou endomagées par des hautes températures de traitement en raison d'une diffusion accélérée des particules à travers les interfaces des différentes couches déposées sur la plaque de silicium.

Dans le domaine des poudres, notamment des poudres formées de grains composites, on connaît des méthodes physico-chimiques de fabrication de poudre, dont les grains comprennent un noyau et une zone périphérique. La composition de la zone périphérique (les couches extérieures) peut être différente de celle du noyau. Ces méthodes ont souvent le désavantage d'être, d'une part, relativement lentes et donc onéreuses, d'autre part, ne permettent souvent pas de former des couches uniformes et fines.

On connaît des méthodes de fabrication de poudres non-composites à partir de gaz au moyen d'un traitement par plasma. Les procédés connus de formation de poudres consomment beaucoup d'énergie et sont relativement lents et onéreux.

Au vu des inconvénients précités, un but de la présente invention est de réaliser un procédé de traitement par plasma performant et fiable en milieu industriel, et un dispositif pour la mise en oeuvre d'un procédé de traitement par plasma performant et fiable en milieu industriel.

Il est avantageux de réaliser un procédé de traitement de surface par plasma, ainsi qu'un dispositif pour la mise en oeuvre du procédé, qui peut être utilisé pour traiter des surfaces de matériaux sensibles aux hautes températures.

Il est avantageux de pouvoir effectuer un dépôt de barrière sur des récipients (notamment en matière plastique, tels que les bouteilles PET dans le domaine de l'industrie alimentaire, les tubes de polyéthylène dans le domaine de la parfumerie et les réservoirs à carburant dans l'automobile), qui est résistant, flexible et qui a une bonne imperméabilité. Il est avantageux de pouvoir traiter simultanément les surfaces extérieures et intérieures d'objet creux (bouteilles, tubes, réservoirs). Il est avantageux de pouvoir traiter la surface d'un objet complexe.

Il est avantageux de réaliser un procédé de traitement de surface par plasma, ainsi qu'un dispositif pour la mise en oeuvre du procédé, qui peut être utilisé pour déposer plusieurs couches de matériaux différents sur une surface à traiter.

Il est avantageux de réaliser un procédé de traitement de surface par plasma, ainsi qu'un dispositif pour la mise en oeuvre du procédé, qui peut être utilisé pour déposer une ou plusieurs couches de matériaux différents sur la surface d'un noyau submicronique ou nanométrique pour former des grains composites de poudre.

Il est aussi avantageux de pouvoir effectuer d'autres traitements de surface tels que le nettoyage, le décapage, l'activation de surface, la stérilisation ou la formation d'alliages superficiels.

Il est en outre avantageux dans beaucoup d'applications de réaliser un procédé de traitement de surface par plasma à pression atmosphérique, ainsi qu'un dispositif pour la mise en oeuvre du procédé.

Des buts de l'invention sont réalisés par le procédé selon la revendication 1.

Dans la présente invention, un procédé de traitement par plasma d'une surface à traiter d'un objet comprend la création d'un plasma, l'application du plasma contre la surface à traiter et l'excitation de la surface à traiter pour créer un mouvement ondulatoire relatif entre la surface à traiter et le plasma. L'énergie pour l'excitation de la surface peut provenir du procédé de création du plasma, ou d'une combinaison de ce dernier avec une source externe Le mouvement ondulatoire a de préférence lieu pendant l'application du plasma contre la surface à traiter, mais en fonction du traitement à effectuer, il peut également avoir lieu juste avant et/ou juste après la phase d'application.

L'énergie pour l'excitation de la surface provenant du procédé de création du plasma peut avantageusement provenir d'une onde de choc qui se développe au front du plasma pendant sa création. L'onde de choc est créée en faisant de sorte que le front de développement du plasma crée dans le plasma une pression telle que son rapport à la pression ambiante soit supérieur à la valeur critique de formation d'une onde de choc du milieu gazeux donné. Ceci s'obtient par le choix et la maîtrise des paramètres de génération du plasma, notamment de la densité d'énergie et de la durée du front de développement du plasma.

L'énergie pour l'excitation de la surface provenant d'une source externe peut provenir d'un générateur de vibrations, mise en contact avec l'objet à traiter, ou sans contact directe avec l'objet à traiter et émettant des ondes acoustiques, par exemple ultrasoniques. La fréquence des vibrations, pour beaucoup d'applications et d'objets ou de particules à traiter, est avantageusement dans la gamme de fréquence des ultrasons. Le générateur externe peut également fournir de l'énergie sous forme d'ondes de choc.

Le mouvement ondulatoire de la surface à traiter peut être le résultat de l'excitation d'une ou plusieurs fréquences propres et leurs harmoniques du corps de l'objet à traiter, suite à un saut brusque d'énergie (choc) éventuellement combiné avec l'action d'un générateur externe émettant une ou plusieurs fréquences proches ou identiques à des fréquences propres ou à leurs harmoniques de l'objet à traiter. Le générateur externe peut aussi émettre des fréquences qui ne sont pas des harmoniques des fréquences propres de l'objet à traiter:

Pour la plupart des applications, le plasma est de préférence créé avec une source d'énergie électrique ou électromagnétique en régime continu ou en impulsions unipolaires ou alternatives ou à haute fréquence. Il peut s'agir par exemple d'une décharge de type capacitive ou inductive, ou d'ondes hautes fréquences. Toutefois, le plasma peut aussi être créé par compression adiabatique ou par ondes de choc, par exemple fournies par un générateur de compression adiabatique, respectivement d'ondes de choc.

Le plasma créé pour un procédé de traitement de surface selon des modes de réalisation avantageux de l'invention peut être pour une grande partie du temps de vie du plasma en déséquilibre thermodynamique.

Le procédé selon l'invention est très avantageux puisqu'il permet l'utilisation d'un plasma froid tout en intensifiant l'interaction du plasma avec la surface à traiter et par conséquent d'optimiser des traitements de surface par plasma pour une large gamme d'applications, y compris les traitements d'objets en matériaux ne supportant que de très faibles hausses de température, tels que le PET et les semi-conducteurs. En effet, le mouvement ondulatoire relatif des atomes et des molécules de la surface à traiter par rapport au plasma intensifie l'action des particules activées du plasma avec la surface à traiter. En raison de l'action intensifiée, le choix du mode de génération du plasma (compression adiabatique, ondes de choc, décharge électrique) est plus large et permet d'optimiser le procédé en fonction des caractéristiques (matériaux, forme, dimensions) de l'objet à traiter et du traitement à effectuer. Il permet notamment d'utiliser un plasma atmosphérique "froid" (dans le sens défini par R.F. Baddour et R.S. Timmins « The Applications of Plasmas to Chemical Process, MIT Press », page 17), c'est-à-dire hors d'équilibre thermodynamique, de sorte que la surface diélectrique à traiter reste froide tout en permettant aux électrons de bombarder la surface pour l'activer. Ce plasma peut par exemple être formé par un réseau de filaments qui apparaissent, se déplaçant le long de la surface et disparaissent en un laps de temps suffisamment court pour ne pas échauffer la surface à traiter. S'agissant du traitement de poudre ou de particules, le plasma peut par exemple être formé dans le volume d'un récipient contenant les particules ou la poudre.

Le procédé selon l'invention permet également d'accélérer le traitement de surface en effectuant l'ionisation et l'activation des particules du plasma à l'aide d'ondes de choc, issues de la création de plasma, lors de leur réflexion de la surface à traiter, d'une part, et, d'autre part, d'intensifier le traitement de surface sans augmentation importante de la température de l'objet à traiter, du fait que les vibrations de la surface à traiter ont un effet sur l'interaction avec le plasma essentiellement équivalent à l'agitation atomique provoquée par une augmentation de température de l'objet.

Le traitement de surface peut être encore intensifié en ajoutant des vibrations d'un générateur de vibrations acoustiques ou d'ultrasons externe, de préférence ajusté pour amplifier les fréquences propres de l'objet à traiter.

L'amélioration de l'interaction du plasma avec la surface à traiter à basse température a beaucoup d'autres conséquences avantageuses. On peut par exemple obtenir des films composites de bonne qualité en effectuant des dépôts successifs de couches adhérant bien au substrat et ayant différentes propriétés physiques, physico-chimiques et mécaniques.

Un autre avantage du procédé selon l'invention est le fait qu'il permet de traiter la surface intérieure d'un objet complexe, sans axes de symétrie, tel qu'un réservoir à carburant.

procédé qui ne fait pas partie de la présente invention est également décrit pour réaliser des poudres dont les grains sont composés d'un noyau et d'une zone périphérique résultant du dépôt d'un film uniforme et homogène d'atomes et/ou de molécules, qui permet de donner à la poudre résultante des propriétés, par exemple optiques, différentes des propriétés de la poudre constituée des noyaux.

Il est décrit de former lesdites poudres composites par un dépôt de film en milieu plasma en particulier, atmosphérique. Le plasma servirait d'une part à échauffer et activer la surface des grains-noyaux avant de les mettre en contact avec les atomes et/ou molécules destinés à générer le film périphérique.

Ce même plasma, ou un plasma généré en aval du premier procédé, par un générateur indépendant, permet d'activer les atomes et molécules d'un mélange gazeux contenant des composantes gazeuses et des vapeurs, notamment surchauffées. Mis en contact avec les noyaux, ce plasma dépose un film atomique (moléculaire) homogène à la périphérie des noyaux, donnant à la poudre résultante des propriétés physico-chimiques, par exemple optiques différentes de celles de la poudre formée des noyaux.

En particulier, les paramètres du plasma assurant le dépôt du film périphérique et du plasma activant les noyaux sont choisis de telle manière que le dépôt s'effectue uniquement sous forme de film homogène.

Les composantes du plasma générant le film sont choisies de manière que les forces d'attraction entre les particules du film aient une composante centripète concourant à solidifier la structure de l'enveloppe de film périphérique. Cette composante est d'autant plus grande que la dimension des noyaux est petite. Elle est surtout importante dans le cas de poudres noyaux submicroniques et nanométriques. Dans ces derniers cas, pour bien séparer les grains-noyaux flottant dans un gaz d'apport (par exemple de l'argon) et d'autre part pour leur communiquer un mouvement artificiel de vibrations, catalysant le processus de dépôt, on les soumet à l'action de vibrations acoustiques en particulier ultrasoniques, générées par un générateur extérieur. Ces vibrations peuvent être générées par le plasma lui-même, dans un mode de génération du plasma par impulsions, tel que décrit ci-dessus.

Un procédé qui ne fait pas partie de la présente invention, est également décrit pour la formation de poudres, comprenant la génération d'un plasma en impulsions dans une enceinte contenant des gaz, et la génération simultanée de vibrations acoustiques dans l'enceinte, les gaz étant décomposés par le plasma pour ensuite former des clusters et des grains de poudre dont le degré de structuration est déterminé par l'action simultanée du plasma et des vibrations acoustiques. Les vibrations acoustiques peuvent provenir d'un générateur externe et/ou du processus de création du plasma, tel que décrit ci-dessus.

Un dispositif de traitement de surface par plasma selon l'invention peut avantageusement comporter un générateur de vibrations acoustiques externe.

Un dispositif de traitement de surface par plasma selon l'invention peut avantageusement comporter un capteur de vibrations. Le capteur de vibrations permet de contrôler et/ou d'analyser les fréquences propres de l'objet à traiter afin d'ajuster le dispositif, par exemple les paramètres du circuit électrique de génération de décharge électrique pour la création du plasma, pour obtenir des ondes de choc faisant vibrer la surface à traiter d'un objet spécifique à traiter, ou pour contrôler le bon fonctionnement du procédé et notamment la qualité des vibrations de la surface à traiter ou du plasma dans un processus industriel. En cas de variations de spectres de fréquence et d'amplitude attendus, on pourrait donc être averti d'une éventuelle défaillance ou d'une réduction de la qualité de traitement effectué.

Un dispositif de traitement de surface par plasma selon l'invention peut avantageusement comporter une ou plusieurs électrodes sous tension munies d'un ou plusieurs conduits d'alimentation de gaz de traitement pour la génération d'une ou une pluralité de faisceaux de plasma par décharge électrique. L'électrode sous tension peut avantageusement être rotative de façon à pouvoir déplacer le ou les plasmas par effets électrostatique et hydrodynamique le long de la surface à traiter.

Le dispositif peut comporter une électrode sous tension, qui est sous forme d'un jet de liquide pouvant effectuer un mouvement relatif par rapport à l'objet à traiter, pour projeter un jet de liquide conducteur contre une paroi de l'objet à traiter pour la création d'un plasma de l'autre côté de la paroi.

Selon un mode de réalisation de l'invention, les électrodes pour la génération d'un plasma par décharge électrique peuvent être connectées à des pôles opposés d'un circuit électrique. Ces électrodes peuvent être utilisées pour la génération d'un plasma de chaque côté d'une paroi d'un objet à traiter, les flux de plasma de chaque côté étant anti-parallèles.

On peut également fournir un dispositif avec au moins deux électrodes sous tension pour traiter des côtés respectifs d'une paroi d'un objet à traiter, les flux de plasma de chaque côté étant parallèles et s'écoulant vers une électrode de mise à terre.

Un dispositif de traitement de surface par plasma selon l'invention peut avantageusement comprendre un bain de liquide dans lequel les objets à traiter, notamment des recipients, sont plongés pendant l'application du plasma contre la surface à traiter intérieure. Il peut s'agir, par exemple, de bouteilles ou d'autres récipients partiellement plongés dans le bain de liquide, le goulot restant en dessus de la surface du liquide. Le liquide est donc en contact avec la surface extérieure du récipient, avec l'avantage de pouvoir refroidir la paroi du récipient de manière très effective et donc de permettre d'augmenter la durée ou l'intensité d'application du plasma. D'autre part, en cas d'utilisation d'une source de vibration externe, le liquide permet d'uniformiser ces vibrations sur la paroi du récipient et donc sur la surface à traiter intérieure du récipient.

Un dispositif de traitement de surface par plasma selon l'invention peut avantageusement comporter un système de contrôle de qualité de la surface après traitement ou lors du traitement, comprenant un rayon laser enregistrant soit la quantité de photons émis par effets non-linéaires lors du passage du rayon laser à travers la surface traitée, soit la diminution de flux de protons primaires due à leur recombinaison suite aux effets non-linéaires, le système de rayon laser étant muni d'un dispositif de détection et d'analyse du rayon réfléchi de la surface à traiter ou traversant la surface à traiter.

Un dispositif de traitement de surface par plasma selon l'invention peut comporter une enceinte dans laquelle sont disposés les objets à traiter et un piston pour comprimer le gaz de traitement dans la partie de l'enceinte dans laquelle sont disposés les objets à traiter, de façon à créer un plasma par compression adiabatique. Le piston peut être entraîné par un dispositif de compression d'air ou d'autres gaz dans la partie de l'enceinte au-dessus du piston.

Un dispositif de traitement de surface par plasma selon l'invention peut avantageusement comporter une enceinte comprenant une partie dans laquelle les objets à traiter sont disposés, et une partie dans laquelle se trouve un gaz de traitement sous pression séparé de l'autre partie par une paroi amovible ou destructible pour permettre la décompression subite du gaz comprimé pour la création d'une onde de choc se déplaçant dans la direction des objets à traiter.

D'autres aspects avantageux de l'invention ressortiront des revendications, de la description ci-après et des dessins annexés, dans lesquels :

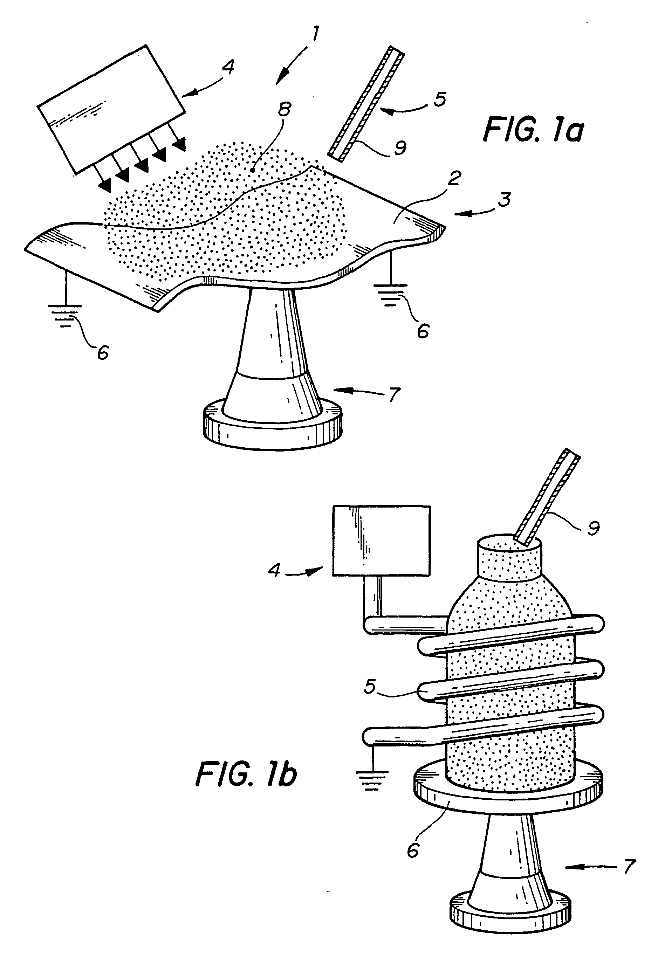

lés Figures 1 a et 1 b sont des illustrations schématiques simplifiées de dispositifs pour le traitement de surfaces d'objets à traiter, selon l'invention;

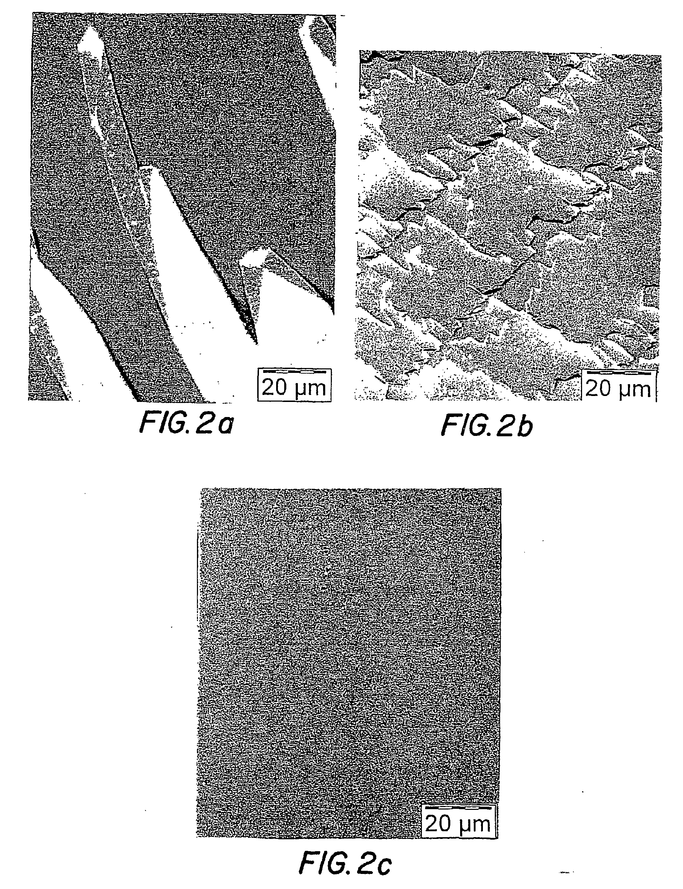

les Figures 2a et 2b sont des photographies de surface par microscope électronique (SEM) de la surface traitée par plasma d'une bouteille PET avec une barrière à base d'oxyde de silicium;

la Fig. 2 est une photographie SEM de la surface traitée d'une bouteille PET avec une barrière à base d'oxyde de silicium obtenue par un procédé comparatif de dépôt par plasma atmosphérique;

les Figures 3a à 3c sont des vues simplifiées en perspective de dispositifs pour le traitement de surfaces par plasma, selon des formes d'exécution de l'invention, dans les cas particuliers du traitement de la surface intérieure de bouteilles;

les Figures 4a et 4b sont des photographies à haute vitesse de bouteilles PET lors de leur traitement de surface par plasma selon l'invention en utilisant un gaz de traitement fait d'un mélange d'hexaméthyldisiloxane, d'oxygène et d'argon, le traitement de la Fig. 4a étant différent du traitement de la Fig. 4b par le niveau de puissance électrique fournie;

la Fig. 5 illustre des courbes de tension $U$ et de courant $I$ en fonction du temps d'un plasma généré par décharges électriques à impulsions selon l'invention, soit en régime unipolaire (graphiques A1 et A2) soit en régime haute fréquence (graphique B);

la Fig. 6 est une vue en section à travers une partie de paroi d'un objet à traiter lors d'un traitement par plasma selon l'invention;

la Fig. 7 est une prise de vue d'un écran d'un oscilloscope connecté à un détecteur de vibrations mesurant les vibrations d'un objet à traiter lors d'un traitement par plasma selon l'invention, en l'occurrence il s'agit d'une bouteille PET 0,5 l lors du traitement par une décharge électrique à impulsions au moyen d'un générateur haute fréquence engendrant un réseau ramifié de filaments de plasma selon l'invention;

la Fig. 8 est une vue en section simplifiée d'un dispositif de traitement de surface par plasma pour un récipient de forme complexe selon l'invention;

la Fig. 9 est une vue en section simplifiée d'une autre forme d'exécution d'un dispositif pour le traitement par plasma d'un récipient de forme complexe, l'électrode de mise à terre étant sous forme d'un jet de liquide conducteur;

la Fig. 10 est une vue en section simplifiée avec un schéma de circuit électrique d'un dispositif pour le traitement de surface par plasma des deux côtés d'une paroi d'un récipient, selon l'invention;

la Fig. 11 est une vue similaire à la Fig. 10 d'une autre variante selon l'invention;

les Figures 12 et 13 sont des vues en section simplifiées avec un schéma de circuit électrique d'un dispositif pour le traitement par plasma de surfaces intérieures d'une pluralité de récipients tels que des bouteilles, le plasma étant généré par décharges électriques à impulsions;

la Fig. 14 est une vue en section simplifiée d'un dispositif pour le traitement par plasma selon l'invention, le plasma étant produit par compression adiabatique (isoentropique);

la Fig. 15a est une vue en section simplifiée d'un dispositif pour le traitement par plasma selon l'invention, le plasma étant produit par détente de gaz comprimé générant une onde de choc;

les Figures 15b et 15 c sont des vues simplifiées d'une partie du dispositif de la Fig. 15a pour illustrer le déplacement des ondes de choc, incidente et réfléchie, et la création du plasma; et

la Fig. 16 est une vue en section simplifiée d'un dispositif pour le traitement par plasma de poudres selon un procédé qui ne fait pas partie de la présente invention.

En faisant référence aux Figures 1 a et 1 b, de manière générale, un dispositif 1 pour le traitement d'une surface 2 d'un objet à traiter 3 comporte un dispositif de génération de plasma 4 comprenant un système d'alimentation de gaz et une électrode 5, et un dispositif de support 6 pour supporter l'objet à traiter. Le dispositif de traitement 1 peut aussi comprendre un générateur de vibrations externe 7 pouvant faire vibrer la surface 2 de l'objet à traiter par un oscillateur en contact directement avec l'objet, ou sans contact direct par ondes soniques (acoustiques).

Un plasma 8 est créé sur la surface 2 de l'objet 3 par le générateur de plasma 4 dans un gaz plasmochimiquement activable dirigé vers la surface 2 par un conduit 9 du système d'alimentation de gaz, le conduit pouvant être formé dans l'électrode 5.

La surface à traiter est excitée de manière à la faire vibrer, c'est-à-dire elle effectue un mouvement ondulatoire. L'énergie pour générer le mouvement ondulatoire de la surface à traiter peut provenir d'une onde de choc résultant du procédé de création du plasma, ou d'un combinaison de cette dernière avec une onde de choc créée par un générateur externe ou un générateur de vibrations externe 7. Une onde de choc fera vibrer, de manière transitoire, un corps à ses fréquences propres. L'amplitude des vibrations peut être augmentée par un générateur de vibrations externe ajusté pour générer des vibrations à une ou plusieurs fréquences propres de l'objet à traiter. Les modes de vibration de corps étant extrêmement complexes, le choix optimum de fréquences peut être déterminé par expérimentation, c'est-à-dire en ajustant la fréquence de manière différente pour chacun d'un certain nombre d'échantillons et de déterminer les propriétés de la qualité du traitement de surface.

Une analyse du procédé de traitement de surface selon l'invention montre que la mise en oeuvre d'un mouvement d'ondulations des particules de la surface à traiter permet d'intensifier l'interaction physico-chimique entre les particules du plasma et celles de la surface. Cette intensification est semblable, de par sa nature et ses effets, à l'intensification qui accompagne l'augmentation de température de la surface à traiter, en contact avec le plasma, que celui-ci soit un plasma de vide, un plasma atmosphérique ou un plasma à haute pression.

Un aspect très important de l'invention est donc d'intensifier le processus d'interaction plasmochimique, que ce soit pour un dépôt de film, un décapage, la création d'un alliage superficiel ou d'autres sortes de traitements, sans augmenter la température de l'objet à traiter de manière significative. Cette solution technologique est très importante et ouvre de grandes perspectives notamment pour le traitement par plasma de corps dont le matériau ne supporte pas les échauffements. D'autre part, elle permet de valoriser d'une nouvelle manière, l'action sur une surface d'un plasma froid, c'est-à-dire, hors d'équilibre thermodynamique et chimique (voir définition dans le livre précité de Baddour et Timmins page 27). En effet, le fait de pouvoir exciter la surface à traiter par une vibration mécanique, la laissant cependant froide, permet de remédier de manière décisive au désavantage d'utilisation d'un plasma froid sur une surface froide du fait de la forte intensification de l'interaction entre le plasma et la surface à traiter.

Les Figures 2a et 2b représentent des photographies SEM (Surface Electron Microscope) de la surface d'une bouteille en PET, d'un volume de contenance de 0,5 l suivant un traitement au plasma sans excitation de la surface à traiter. Dans ce cas, il s'agit d'un dépôt de film d'oxyde de silicium. Le plasma utilisé dans cet exemple est un plasma de décharge HF (haute fréquence), à impulsions, généré dans un mélange de vapeurs d'hexaméthyldisiloxane et d'argon. Après traitement, la bouteille a été pliée mécaniquement et on observe sur ces photos des copeaux 10 et des écailles 11 formés sur la surface. Ces copeaux et écailles peuvent se détacher et s'intégrer au liquide, représentant un danger pour le consommateur. D'autre part, ils diminuent la perméabilité de la surface. Les tests sur ces bouteilles ont permis d'établir que l'imperméabilité BIF (Barrier Improvement Factor) du film barrière pour l'oxygène était environ 10 par rapport à une surface non traitée. Dans le cas de la Fig. 2c, le même traitement de surface a été effectué avec l'adjonction de vibrations d'une fréquence environnant 21 KHz, c'est-à-dire dans le domaine des ultrasons, par un générateur à ultrasons externe. La température des parois PET de la bouteille a été mesurée pendant le traitement par un thermo-couple, le résultat étant que la température n'a pas dépassé 45° C. Cette température est bien en-dessous de la température maximale de traitement du PET d'environ 60 à 70° C. La bouteille a ensuite été pliée mécaniquement de la même manière que les échantillons des Figures 2a et 2b, et on constate sur la photo prise par SEM que le film barrière obtenu est solide et flexible puisqu'il ne forme ni copeaux, ni écailles. Le niveau d'imperméabilité du film barrière est très élevé et selon les mesures des échantillons, le BIF est environ égal à 30 pour l'oxygène par rapport à une surface non traitée.

Il est à noter que le procédé selon l'invention permet d'utiliser un plasma dans le vide, à pression atmosphérique, ou à haute pression, puisque l'efficacité des vibrations de la surface à traiter sur l'interaction de cette surface avec le plasma ne dépend pas de manière significative de la pression à laquelle est généré le plasma. D'autre part, l'efficacité du traitement ne dépend pas non plus de manière significative de la façon dont le plasma est généré, que ce soit de manière continue, alimenté par des sources de courant continu, alternatif, à haute fréquence et à micro-ondes, ou par impulsions. Dans ce dernier cas, la durée d'une impulsion est de préférence supérieure à la période de vibration à laquelle l'objet à traiter est soumis, afin d'assurer que le contact entre le plasma et la surface à traiter s'effectue.

L'onde de choc provenant de la création du plasma peut être générée par l'échauffement isochorique d'une fraction du volume de gaz plasmochimiquement activable en émettant une décharge électrique en impulsion respectant certains paramètres, directement dans le gaz de traitement. La fraction de volume en question s'échauffe, sa pression augmente rapidement et dépasse la pression critique au-dessus de laquelle se forme une onde de choc qui se propage dans tout le volume du mélange gazeux, suivie d'un plasma formé de particules du gaz de traitement, échauffées, excitées, et ionisées. Ce procédé est surtout efficace lorsque les impulsions de courant électrique sont effectuées le long de la surface du corps à traiter, celui-ci étant formé de matériaux diélectriques. Il peut avantageusement être utilisé pour traiter une surface complexe, telle que la surface à l'intérieur de bouteilles, de tubes, de réservoirs à carburant, et autres recipients.

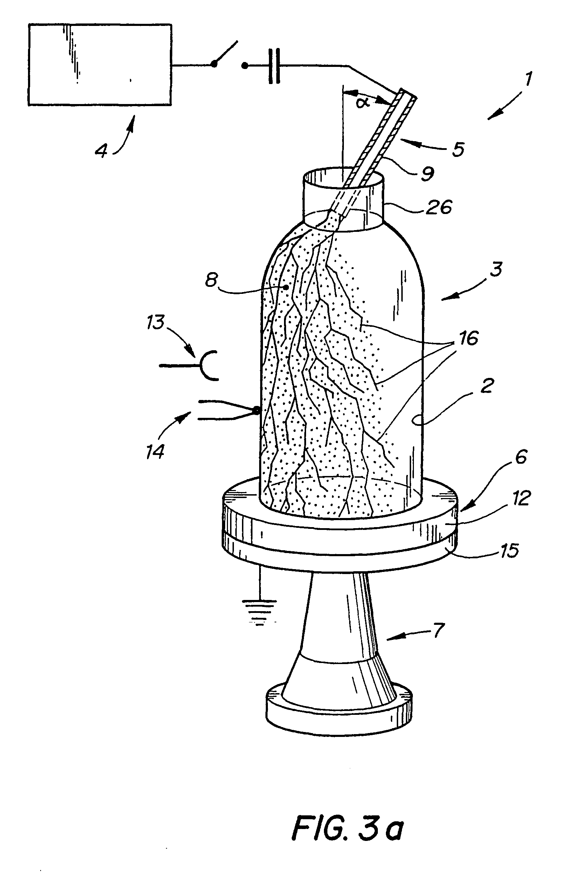

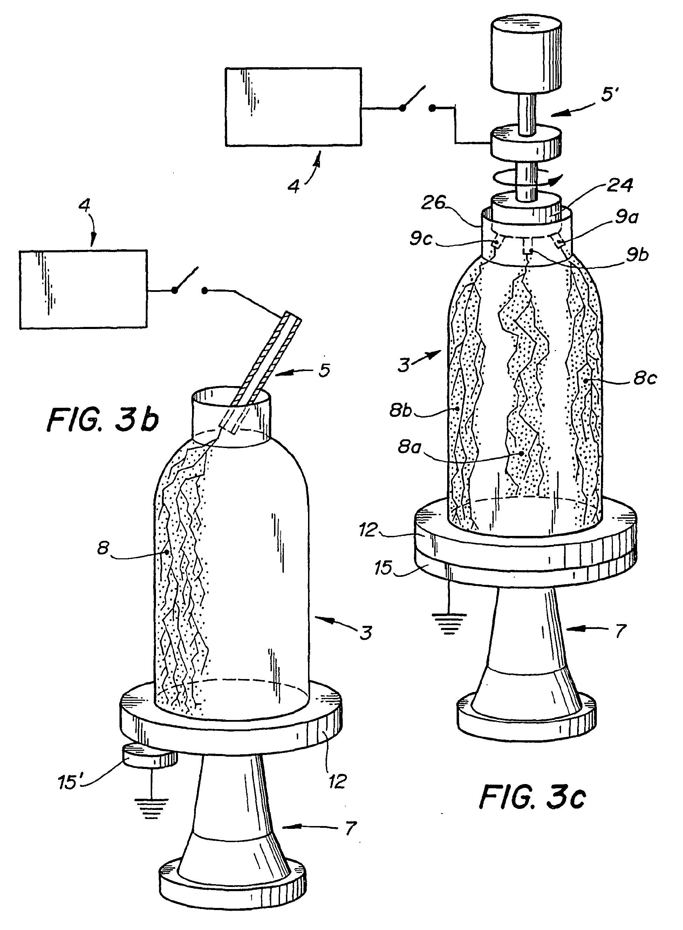

Dans la Fig. 3a, un dispositif 1 pour le traitement d'une surface 2 intérieure d'un objet à traiter 3, en l'occurrence une bouteille, comprend un dispositif de génération de plasma 4 par décharges électriques en impulsions muni d'un système d'alimentation de gaz comprenant un conduit 9 qui peut également agir en tant qu'électrode 5 sous tension, un dispositif de support 6 comportant un élément diélectrique 12 pour supporter l'objet à traiter, et une électrode de mise à la terre 15. Le dispositif de traitement 1 peut aussi comprendre un générateur de vibrations externe 7, en l'occurrence un générateur à ultrasons, pouvant faire vibrer la surface 2 intérieure de la bouteille, un capteur de vibrations 13 qui peut être relié à une unité de commande du générateur de vibrations 7, et un capteur de temperature 14, tel qu'un thermocouple, pour contrôler la temperature de la paroi du recipient.

Un plasma 8 est créé à l'intérieur du récipient 2 par des impulsions de courant s'écoulant de l'électrode centrale 5 fonctionnant en régime d'émission par champ électrique ou auto-électronique (tel que défini dans la monographie : S. Krapivina. Procédés plasmochimiques en technologie. Ed. Chimie, Leningrad, 1981, page 27) à l'électrode de mise à la terre 15. L'électrode de mise à la terre 15 est disposée et formée de manière à pouvoir supporter l'amplitude du champ électrique appliqué et de permettre la création de décharges de plasmas ramifiés formés par un réseau superficiel de filaments de plasma 16. L'amplitude du champ électrique appliqué doit être suffisante pour assurer l'initiation de la décharge par claquage.

L'électrode 5, qui remplit également le rôle de conduit 9 par lequel le gaz de traitement est introduit dans le récipient, peut être inclinée sous un angle $\alpha$ par rapport à l'axe de symétrie du récipient pour favoriser la formation du plasma le long de sa surface intérieure 2. On utilise un gaz à faible énergie d'ionisation, tel que l'argon, pour optimiser la localisation de la décharge le long de la surface intérieure du récipient.

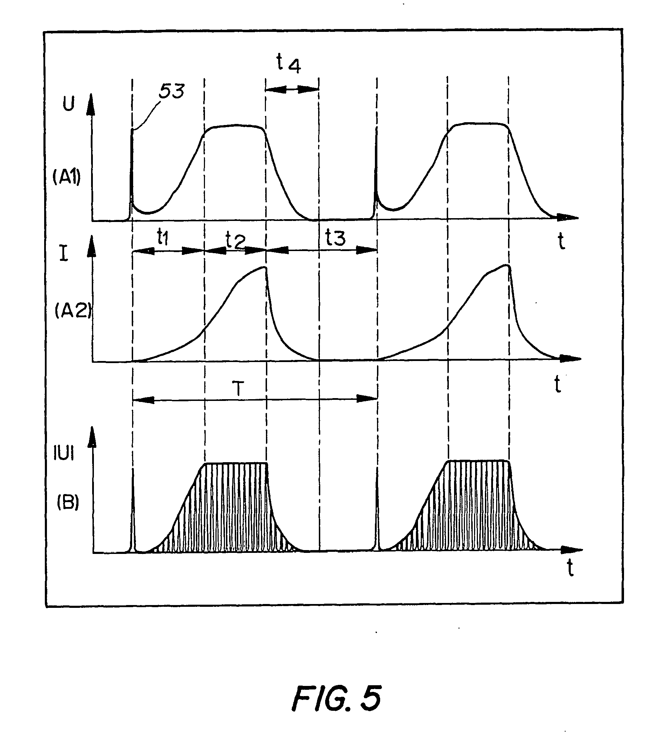

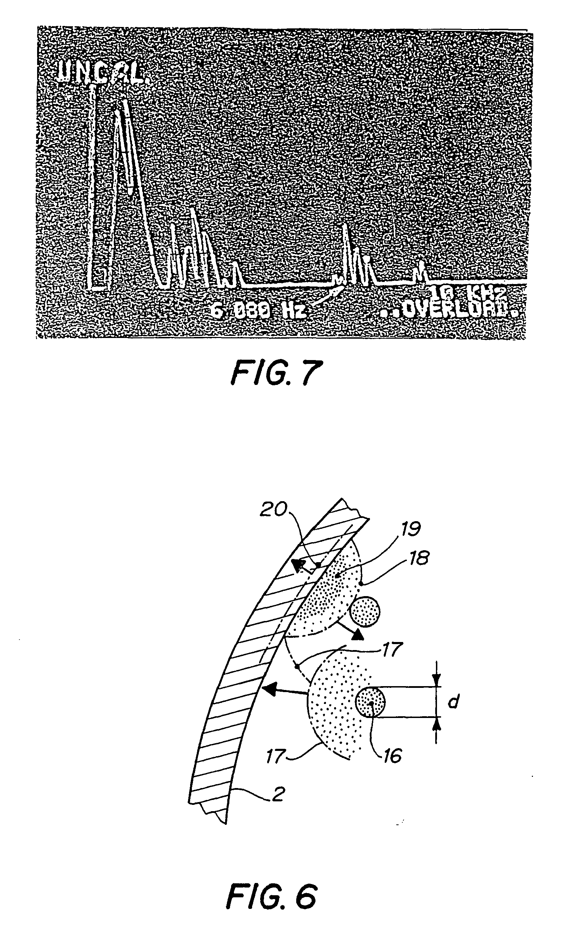

En faisant référence aux Figures 5 et 6, la décharge de plasma ramifiée est développée par une impulsion de courant (I), dont le front de croissance a une durée $t_1$ telle que le plasma à l'intérieur des filaments de la décharge ramifiée commence par se former et s'échauffer isochoriquement. La plage indiquée par $t_1$ dans la Fig. 5 correspond à la phase d'échauffement isochorique des filaments de plasma. On a pour $t_1$ la relation $t_1 < d/a$ où d est le diamètre du filament lors de sa création et a est la vitesse du son dans le milieu non ionisé qui entoure le filament. Typiquement, $d \sim 1$ mm et $a \sim 3 \cdot 10^2 m/s$, de sorte que $t_1 < 3 \cdot 10^{-6} s$.

Au bout du laps de temps $t_1$, la hausse de pression à l'intérieur du filament dépendant des caractéristiques de développement de la décharge, notamment l'échauffement du plasma alimenté en énergie par le courant, génère une onde de choc qui excite et ionise le gaz autour du filament. L'activation est surtout intense dans la zone 19 entre le filament de plasma 16 sur la surface à traiter 2 en raison du croisement de l'onde incidente 17 et de l'onde réfléchie 18

EP 1 374 276 B1

de la surface à traiter. Le courant initialement localisé dans ce filament après le développement des ondes de choc mentionnées passe principalement dans la zone 19 limitée à l'onde réfléchie 18 dans laquelle se développe un plasma froid hors d'équilibre thermodynamique et ayant un très bon contact avec la surface à traiter.

L'amplitude de l'énergie développée par l'impulsion du courant électrique est telle qu'une partie de l'énergie de l'onde de choc incidente est transmise au matériau de l'objet à traiter par l'intermédiaire d'une onde de choc pénétrante 20 qui se dissipe sous forme de vibrations à des fréquences propres de l'objet à traiter qui peuvent être dans le domaine des fréquences audibles ou dans le domaine des fréquences des ultrasons. La présence des vibrations peut avantageusement être contrôlée à l'aide d'un capteur acoustique 13 du dispositif de traitement. Ces vibrations acoustiques soumettent les atomes de l'objet à traiter à des oscillations qui les éloignent et les rapprochent de leur position d'équilibre statique créant, lors de leur éloignement, une situation favorable à leur liaison chimique avec les particules du milieu ionisé et activé par le plasma, par exemple des atomes de silicium et d'oxygène lors du dépôt d'un film $SiO_x$.

La Fig. 7 montre le résultat de l'enregistrement des fréquences de vibration d'une bouteille PET (0.5 l) pendant le traitement par une décharge HF à impulsions engendrant un faisceau ramifié de filaments de plasma selon l'invention. On constate que les paquets de vibrations acoustiques ayant une relativement grande amplitude ont notamment des fréquences d'environ 6080 Hz et 10'000 Hz.

Les vibrations acoustiques, notamment dans le domaine des ultrasons, jouent lors du traitement de surface un rôle catalysant similaire à l'augmentation de la température de l'objet à traiter. L'avantage des vibrations ultrasoniques est que l'objet à traiter reste relativement froid par rapport à des procédés conventionnels de traitement par plasma, puisque l'énergie des vibrations ultrasoniques se dissipe dans le volume avoisinant l'onde de choc et non localement. L'échauffement de l'objet à traiter dû à la dissipation des ondes sera donc relativement faible.

L'impulsion de courant doit néanmoins être limitée dans le temps. En effet, l'énergie développée lors du passage du courant dans le plasma, qui est d'abord hors d'équilibre thermodynamique, se dépense d'une part à activer les particules des gaz d'apport (par exemple, $O_2$, O, Si, éventuellement C, H) et d'autre part à échauffer l'objet à traiter ainsi que le plasma dont le volume augmente. Ces derniers effets représentent un certain désavantage pour le traitement de surface et devraient être limités. En effet, dans le cas du dépôt de film sur la surface à traiter, l'échauffement du plasma en volume favorise la formation de poudre qui se dépose sur la surface à traiter et la contamine, avec la conséquence par exemple d'une mauvaise adhésion du film sur la surface à traiter et d'une mauvaise qualité de la barrière.

Revenant à la Fig. 5, la plage indiquée par $t_2$ dans la Fig. 5 correspond à une phase de détente des filaments de plasma. La durée $t_2$ de l'impulsion de courant est choisie de telle manière que le plasma reste froid et se développe le long de la surface à traiter et que la température de l'objet à traiter ne dépasse pas sa température de destruction. Ceci peut être contrôlé par une mesure de la température de l'objet pendant ou immédiatement après son traitement avec un capteur de température, par exemple un thermocouple 14 que l'on positionne à proximité ou sur l'objet à traiter comme montré dans la Fig. 3 et qui est relié au dispositif de génération de plasma 4. Dans un procédé industriel, le capteur peut être utilisé dans la phase de mise en route pour l'ajustement et l'étalonnage des paramètres de génération de plasma, et notamment la durée de l'impulsion $t_2$ et la durée entre impulsions $t_3$.

D'autre part, la durée de l'impulsion de courant $t_2$ doit être assez longue pour activer et précipiter un nombre maximum de particules du milieu plasmo-chimiquement activé sur la surface à traiter, ce qui se contrôle par l'évaluation même du résultat du traitement sur un certain nombre d'échantillons.

Comme les filaments de plasma qui engendrent le mécanisme décrit plus haut, sont relativement distants les uns des autres, il y a lieu de répéter les impulsions pour recouvrir uniformément la totalité de la surface à traiter. Afin que les filaments ne viennent pas, lors d'une nouvelle impulsion, se reposer sur le site des filaments précédents, le laps de temps $t_3$ entre deux impulsions devrait être plus grand que le temps de vie du plasma en "post-décharge" $t_4$ (tel que déterminé, par exemple, dans la monographie A. Ricard, Plasmas Réactifs SFV, 1995) et suffisamment grand pour permettre aux particules précipitées sur la surface à traiter et mises en contact avec les propres particules de la surface à traiter, d'y atteindre leur état stable (ou métastable) définitif, déterminant les propriétés requises de la surface à traiter.

Par exemple, dans le cas du dépôt de film polymérique basé sur la précipitation par plasma d'un mélange de particules activées de C, H, et $CH_y$, le temps $t_3$ entre les impulsions de plasma devrait permettre de parachever le processus de polymérisation sur la surface à traiter entre les impulsions de plasma. Ce parachèvement est avantageusement accéléré par la présence de vibrations acoustiques.

Pour des plasmas contenant des composantes telles que $O_2$, $N_2$, $H_2$, Si, et C, la durée entre impulsions sera de préférence $t_3 \geq 1$ à 10 msec.

Avantageusement, une vibration acoustique, de préférence dans le domaine de fréquences d'ultrasons, appliquée à l'objet à traiter avant le traitement par plasma, a l'avantage de promouvoir l'expulsion de gaz étrangers absorbés dans les couches superficielles de la surface à traiter. L'expulsion de ces gaz absorbés permet lors de l'échauffement local du matériau par le plasma, d'éviter la création d'un flux de ces gaz allant à l'encontre du flux des particules activées du plasma, les empêchant d'atteindre la surface à traiter.

Avantageusement, une vibration acoustique appliquée à l'objet à traiter après le traitement par plasma permet d'expulser les gaz résiduels et les particules de poudre, éventuellement adsorbés sur la surface traitée lors du traitement.

Les vibrations acoustiques de l'objet à traiter dues à la création d'un réseau ramifié de filaments de plasma selon l'invention peuvent être complémentées par des vibrations acoustiques, en particulier ultrasoniques, d'une source externe, telle qu'un générateur de vibrations ultrasoniques. La fréquence peut être choisie égale à une des fréquences propres de l'objet à traiter, mesurables par un capteur de vibrations. Dans ce cas, l'effet de résonance améliore substantiellement la qualité du traitement opéré. Il y a d'autres fréquences avantageuses qui permettent d'amplifier la vibration ultrasonique de l'objet à traiter, notamment la fréquence $a/D$ où D est le diamètre du récipient et a la vitesse du son.

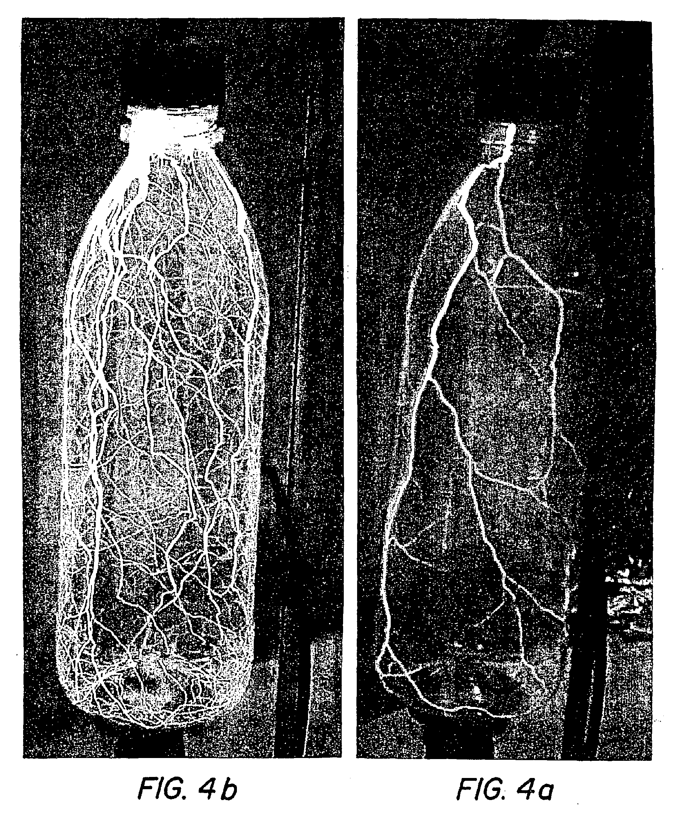

Les Figures 4a et 4b montrent des photos prises à l'aide d'une caméra à haute vitesse d'une décharge de plasma ramifiée généré avec un dispositif tel que décrit en rapport avec les Figures 3, 5 et 6. La bouteille dans le cas illustré repose sur une plaque, mise à la terre et en contact avec un générateur de vibrations acoustiques. Les paramètres de création du plasma dans ces exemples sont:

Figures 4a et 4b
$t_1$ = 2μsec
$t_2$ = 300μsec
$t_3$ = 2μsec
Exposition de la prise photographique : 0,5msec
Fréquence des vibrations du générateur de vibrations externe: f=120 kHz
Figure 4a
Potentiel électrique seuil U = 15kV;
gaz de traitement: argon
Figure 4b
Potentiel électrique seuil U= 10kV ;
gaz de traitement: mélange de hexaméthyldisiloxane, oxygène, argon

Les filaments ramifiés de plasma qui sont créés, se déplacent rapidement le long de la surface à traiter et disparaissent. Chaque décharge est précédée d'un claquage superficiel tel que représenté par le pic de tension 53 dans la Fig. 5, qui crée un canal précurseur. Le temps de vie de ces filaments ramifiés correspond à la fréquence des impulsions de la source de courant qui les crée. Comme on peut constater sur les photos le réseau de filaments recouvre une grande partie de la surface à traiter et les filaments épousent les non-uniformités de cette surface, y compris le fond.

Les inventeurs de la présente invention ont réalisé que dans des procédés conventionnels, le plasma ait tendance à se détacher de la surface de l'objet à traiter, du fait que le déplacement de l'objet ou de l'électrode crée des mouvements de gaz qui perturbent le plasma et notamment les afflux d'air apportés par la couche limite de la paroi du récipient et qui tendent à repousser le plasma de la surface à traiter. L'éloignement du plasma de la surface à traiter diminue ou annule le gradient de concentration des particules actives sur la surface à traiter et empêche ainsi le traitement de surface, tel que le dépôt d'un film. Dans le cas de la présente invention, le problème est évité par le fait que la durée de l'impulsion de courant créant le plasma sous forme de réseau ramifié de filaments est choisie assez courte pour que le déplacement relatif de la surface à traiter par rapport au site du réseau soit si petit que la durée de l'impulsion $t_2$ soit inférieure au rapport *(d/v)* de la largeur *(d)* d'un filament à la vitesse (v) de déplacement de la surface à traiter par rapport au plasma. Supposons que cette vitesse soit de 1m/s (vitesse souvent réalisée en pratique) et que la largeur du filament soit de 1 mm, on obtient pour $t_2$ la valeur maximum de $10^{-3}$ sec. En réalité, la durée de l'impulsion $t_2$ est soumise à une condition plus stricte qui est la limitation de la température d'échauffement de la surface à traiter. Les essais faits dans le cadre du développement de cette invention montrent que, de préférence, la durée de l'impulsion $t_2$ a une valeur ne dépassant pas environ $3.10^{-4}$ sec. Pendant ce laps de temps, les photos à haute fréquence, telles que dans les Figures 4a, 4b, montrent que les filaments restent appliqués à la surface à traiter, et aucun effet hydrodynamique n'est observé.

Afin d'assurer un balayage optimal de la surface à traiter par le réseau de plasma ramifié, tel que montré dans les Figures 3a et 3b, on peut, par la forme et la position de l'électrode de mise à terre 15, éloigner ou rapprocher les filaments de plasma les uns des autres, en d'autres mots, varier la densité du faisceau de filaments de plasma. On voit par exemple dans la Fig. 3a un faisceau ramifié peu dense, et dans la Fig. 3b un faisceau de filaments de plasma très rapprochés, en raison de la réalisation d'une électrode 15' de petite surface disposée radialement à l'extérieur, par rapport à l'axe de symétrie de la bouteille, sous le support diéletrique 12.

Pour que le plasma balaie toute la surface du récipient, on peut effectuer un déplacement relatif entre l'électrode de mise à terre et l'objet à traiter, par exemple en tournant le support 12 sur lequel se trouve le récipient ou en tournant l'électrode sous tension ou mise à la terre et en maintenant le support fixe, ou encore en déplaçant un champ magnétique ou électromagnétique, ou en générant un effet hydrodynamique des gaz de traitement.

Pour simplifier le dispositif, on peut avantageusement obtenir le balayage du plasma le long de la surface à traiter par le déplacement de la buse d'alimentation de gaz de traitement, par exemple en effectuant une rotation autour de l'axe d'axisymétrie de la bouteille, comme montré dans les Figures 3a à 3c. On peut encore améliorer le balayage par un dispositif de traitement tel que montré dans la Fig. 3c, comportant un dispositif d'alimentation de gaz 5' muni

**EP 1 374 276 B1**

d'une tête d'alimentation 24 ayant une pluralité de conduits 9a, 9b, 9c inclinés à un angle α par rapport à l'axe de symétrie de la bouteille et distribués autour de cet axe de symétrie. Les conduits 25 peuvent également servir en tant qu'électrodes liées au dispositif de génération de plasma 4. La tête d'alimentation 24 peut être montée d'une manière rotative par rapport au support 12 du récipient 3. Le dispositif permet de générer une pluralité de faisceaux de plasma ramifié 8a, 8b, 8c, distribués autour de la surface intérieure de ce récipient. Le fait de tourner les conduits d'alimentation du gaz de traitement fait tourner le plasma par effets hydrodynamique et électrostatique. D'autre part, l'effet hydrodynamique améliore aussi l'évacuation des gaz résiduels après traitement.

La surface entière du récipient peut donc être traitée soit par un ou plusieurs passages du plasma où il y a un déplacement de l'électrode mise sous tension et servant en tant que conduit d'alimentation de gaz de traitement ou de l'électrode mise à la terre, soit par des impulsions répétées sur toute la surface à traiter sans déplacement de ces derniers.

Un moment important dans la mise en oeuvre du procédé est l'apport du mélange de gaz sur la surface à traiter. Les gaz apportant les molécules, pour le dépôt du film imperméable par exemple, peuvent être mélangés avec le gaz pour la formation du plasma et alimentés par le conduit 9, 9a, 9b, 9c dans l'électrode sous tension, ou être présents dans le récipient 3 avant le début de traitement de surface, ou être alimentés dans le récipient par une source séparée. La buse de l'électrode sous tension peut diriger les gaz pour le revêtement de film en aval de la formation du plasma. Il est important que la tension de claquage dans le mélange gazeux soit inférieure à celle de l'air ambiant. Pour cette raison, le mélange gazeux contient de préférence de l'argon. Le système d'alimentation prévoit l'utilisation consécutive de plusieurs mélanges gazeux de composition différente, permettant de créer un film-barrière, par exemple, sous forme de plusieurs couches de composition chimique différente. On peut avantageusement terminer le dépôt du film-barrière à l'intérieur d'une bouteille par un dépôt d'une couche organique du type $C_xH_y$ empêchant le moussage d'un liquide carbonaté introduit dans la bouteille par la suite.

Un endroit critique de l'objet à traiter, notamment dans le cas des objets ayant un goulot étroit tel que les bouteilles ou la partie de surface intérieure proche de l'extrémité ouverte du récipient (par exemple d'un tube cylindrique en plastique), est la partie de surface intérieure inclinée ou évasée proche du goulot. Pour assurer un traitement de surface efficace de cette partie, il est avantageux d'incliner les conduits 9a, 9b, 9c d'un angle α par rapport à l'axe d'axisymétrie du récipient ou tout au moins la partie à proximité de la partie du goulot 26.

Dans le cas particulier où l'objet à traiter est un tube en plastique, il s'avère important, par exemple lors d'un traitement de dépôt de barrière, de ne pas traiter l'extrémité du tube devant être fermée, étant donné que le film déposé peut empêcher le soudage de cette extrémité après remplissage du tube par un produit de consommation. L'angle α, dans ce cas, est choisi de manière à ce que le mélange gazeux apporté par l'intermédiaire des conduits 9, 9a, 9b, 9c ne contacte la paroi à traiter qu'en dessous de la surface annulaire à ne pas traiter. Dans le cas particulier où l'on traite une bouteille, il est possible de ne recouvrir en fin d'opération que la partie inférieure de la bouteille d'une couche polymérique empêchant le moussage de la boisson lors du remplissage, le goulot n'ayant pas cette couche et donc favorisant le moussage. Cela aurait comme résultat de faire mousser la boisson lors de son vidage, effet qui est recherché dans le cas de la bière.

Le choix adéquat de l'angle α permet aussi de minimiser l'accumulation des produits résiduels du traitement en permettant une circulation des gaz vers le côté ouvert du récipient, dans le présent cas le goulot. Il est aussi possible d'injecter les gaz d'apport sous forme d'un cône coaxial à un objet à traiter axisymétrique, de manière à distribuer uniformément les gaz d'apport sur toute la surface à traiter. Les gaz résiduels sont dans ce cas évacués par un conduit d'évacuation central le long de l'axe de ce cône.

Le contact du plasma avec la surface à traiter par un procédé selon l'invention, permet de déposer des couches barrières, par exemple contenant du $SiO_x$ qui est peu coûteux et bien adapté aux récipients destinés aux aliments, par les effets suivants. D'abord, les gaz absorbés dans la paroi de l'objet à traiter sont désorbés par l'effet acoustique d'une onde de choc provenant de la création du plasma, et/ou de la source extérieure de vibrations ultrasoniques, et sont ainsi éliminés de la couche superficielle de la paroi. Le plasma peut éventuellement effectuer un décapage superficiel de quelques couches atomiques de sorte qu'il y a une libération de liaisons chimiques qui réagissent avec les particules excitées dans le plasma, notamment certaines particules telles que le silicium et l'oxygène apportés par le gaz de traitement de surface. Le mécanisme n'est pas parfaitement connu, mais il se peut que les molécules de $SiO_x$ occupent les liaisons chimiques à la surface du polymère, agissent en tant que centre de cristallisation, pour la formation d'une couche barrière de $SiO_x$ sur la surface à traiter.

Pour créer des films-barrière flexibles, non cassants, avec une bonne adhésion à la paroi, il est possible, par la présente invention, de déposer successivement des couches de différentes compositions chimiques, notamment de superposer des couches de $SiO_x$ et de $CH_y$ qui adhèrent bien au substrat et à l'une et à l'autre.

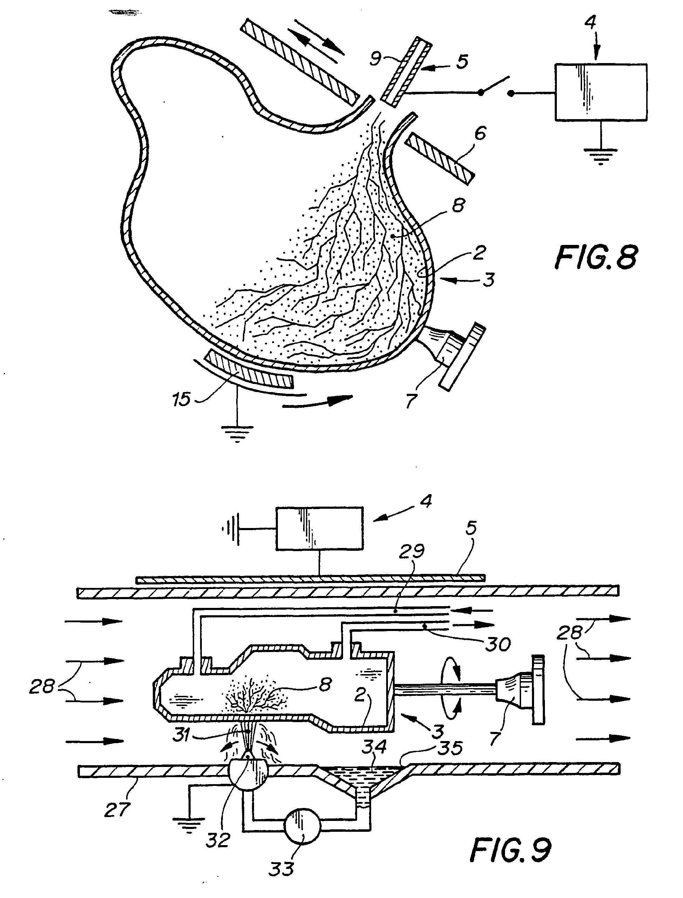

Dans la forme d'exécution de la Fig. 8, pour le traitement de la surface intérieure 2 d'un récipient 3 de forme complexe, la décharge par impulsions de plasma sous forme d'un réseau de filaments de plasma 8 est formée entre une électrode sous tension 5 faisant également office d'un conduit de gaz de traitement et une électrode mise à la terre 15 pouvant être déplacée dans trois dimensions par un mécanisme (non montré) permettant à l'électrode 15 de parcourir toute la surface extérieure du récipient pour entraîner un réseau ramifié de filaments de plasma sur toute la surface

11

intérieure 2 du récipient.

Dans la forme d'exécution de la Fig. 9, le traitement de surface 2 d'un récipient 3 de forme complexe (par exemple un réservoir à carburant) est effectué de la manière suivante. Une électrode sous tension 5 alimentée par une source de courant 4 est située à l'extérieur d'une enceinte 27 du dispositif. Le récipient 3 est placé à l'intérieur de l'enceinte 27 en matériau diélectrique qui est ventilée par un flux d'air ou d'un autre gaz 28. Deux conduits 29, 30 permettent, respectivement, d'amener le mélange gazeux dans le réservoir 3, et d'évacuer les gaz résiduels du réservoir. Le réservoir peut être déplacé et pivoter grâce à un mécanisme supportant le réservoir (non montré).

L'électrode mise à la terre peut être sous forme d'un jet de liquide électroconducteur 31 provenant d'un injecteur 32 alimenté par une pompe 33. Le liquide électroconducteur 34 recueilli dans le fond 35 de l'enceinte est continuellement renvoyé dans le système de l'électrode à la terre. La décharge entre lesdites électrodes se développe sous forme d'un réseau ramifié de filaments de plasma 8.

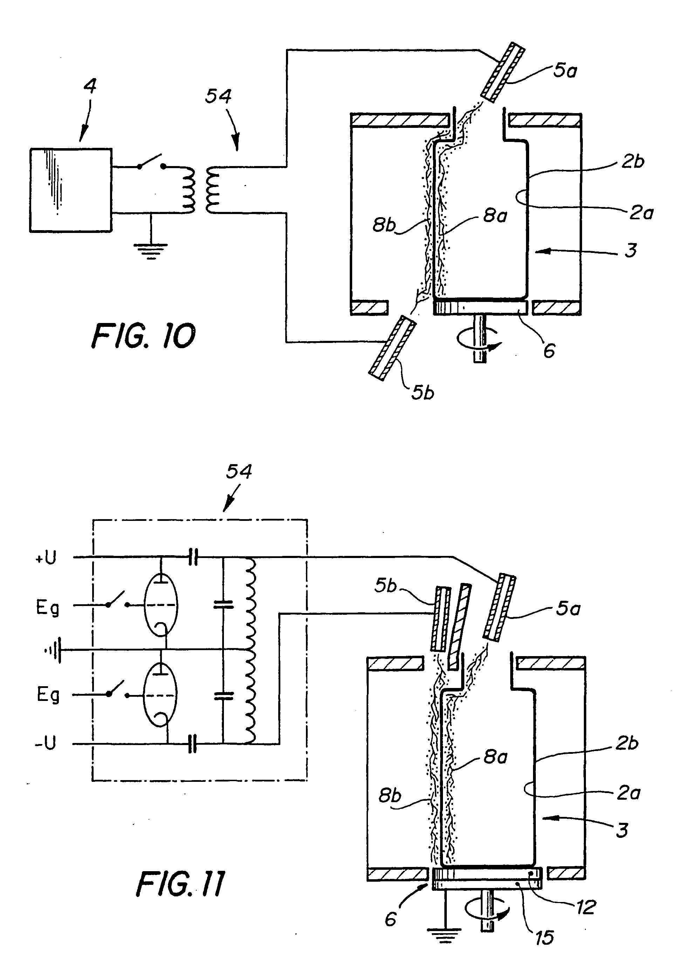

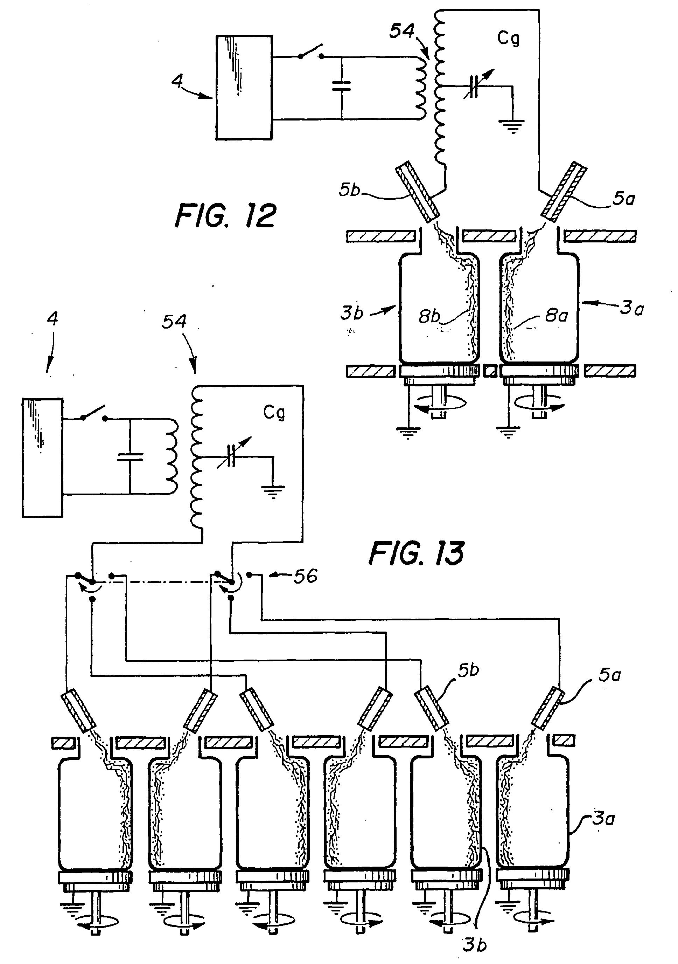

Dans les formes d'exécution des Figures 10 et 11, deux solutions sont montrées pour le traitement simultané des faces 2a, 2b interne et externe d'une paroi d'un récipient 3 en matière diélectrique.

Dans la forme d'exécution de la Fig. 10, les décharges sont produites de façon à ce que les réseaux ramifiés de filaments de plasma 8a, 8b sont formés de chaque côté de la paroi de manière alternée, les deux électrodes 5a, 5b étant connectées à des pôles opposés du circuit électrique 54 du dispositif de génération du plasma 4. Le récipient est placé sur un support 6 en matériau diélectrique qui peut être entraîné en rotation.

Dans la forme d'exécution de la Fig. 11, le schéma électrique proposé permet d'effectuer les décharges sous forme de réseaux ramifiés de filaments de plasma 8a, 8b de chaque côté de la paroi du récipient alimentés en parallèle. Le récipient 3, dans ce cas, est placé sur un support 12 et les deux décharges utilisent une électrode commune mise à la terre 15.

Dans ces deux formes d'exécution, les électrodes 5a, 5b sous tension servent de conduits de gaz. Les mélanges gazeux alimentant les décharges peuvent différer de part et d'autre de la paroi du récipient, de manière à former éventuellement des dépôts de compositions et de propriétés différentes.

Dans la forme d'exécution de la Fig. 12, les décharges sont produites de façon à ce que les réseaux ramifiés de filaments de plasma 8a, 8b sont formés sur les surfaces intérieures de deux récipients 3a, 3b placés l'un à côté de l'autre. Les deux électrodes 5a respectivement 5b sont connectés à des pôles opposés du circuit électrique 54 du dispositif de génération de plasma 4, de sorte que les plasmas 8a, 8b s'attirent par force électrostatique, ce qui aide à les appliquer contre la surface de la paroi interne des récipients 3a respectivement 3b.

Comme pour les autres formes d'exécution, les récipients 3a, 3b peuvent être placés sur des supports diélectriques 12 entraînés en rotation, comprenant également une électrode mise à la terre 15.

Une pluralité de paires de récipients 3a, 3b alimentés par des paires d'électrodes 5a, 5b connectées à des pôles opposés d'un circuit électrique 54, tel que montré dans la Fig. 13, peuvent être traités successivement au moyen d'un commutateur électrique ou électronique 56.

Dans les formes d'exécution des Figures 12 et 13, il est à remarquer que la formation de réseaux ramifiés de filaments de plasma 8a, 8b contre les surfaces internes des récipients placés à proximité l'un de l'autre, est avantageuse en raison d'une meilleure application des plasmas contre les surfaces à traiter, résultant de leur attraction mutuelle. Les plasmas épousent donc mieux la forme intérieure des récipients, assurant donc un traitement plus uniforme et plus effectif sur toute la surface interne du récipient.

Le procédé revendiqué peut être mis en oeuvre sur un équipement composé essentiellement de deux convoyeurs alimentant et évacuant les objets à traiter et un carrousel à la périphérie duquel se déplacent les objets à traiter, chacun d'eux étant muni d'un système de distribution des mélanges gazeux, d'une source de courant, des dispositifs correspondants de mesures et de contrôles, et d'une ou de plusieurs sources de vibrations acoustiques, en particulier d'ultrasons, assurant la mise en oeuvre du procédé. Les sources de vibrations acoustiques peuvent être montées sur les supports de fond des récipients de manière à augmenter l'efficacité du traitement sur la surface de fond du récipient. Les sources de courant peuvent desservir les objets à traiter par groupes.

Chaque objet à traiter peut éventuellement être soumis à un refroidissement à l'air par convection forcée sur la paroi non traitée de l'objet, par exemple du côté non traité s'il s'agit d'un récipient, pendant son traitement.

Un mode de réalisation de l'invention peut consister à plonger les objets à traiter dans un liquide par l'intermédiaire duquel ils sont soumis à l'action uniforme sur toute leur surface, de vibrations acoustiques, en particulier ultrasoniques. Il peut s'agir, par exemple, de bouteilles ou d'autres récipients partiellement plongés dans le bain de liquide, le goulot restant au sec, le liquide étant donc en contact avec la surface extérieure du récipient, avec l'avantage de pouvoir refroidir la paroi du récipient de manière très effective et donc de permettre d'augmenter la durée d'application du plasma. D'autre part, en cas d'utilisation d'une source de vibration externe, le liquide permet d'uniformiser ces vibrations sur la paroi du récipient et par conséquent les vibrations de la surface à traiter intérieure du récipient.

Pour simplifier les connexions électriques du dispositif de traitement, on peut le munir d'un système de condensateurs à travers lesquels l'énergie électrique haute fréquence (HF) est transmise aux électrodes sous tension sans contact direct.

Dans le cas du dépôt de films sur des récipients en matière amorphe transparente, le dispositif de traitement peut avantageusement comprendre un système de rayons laser pour contrôler la qualité du film déposé. Un tel système enregistre soit la quantité de photons émis par effets non-linéaires lors du passage de rayon laser à travers ledit film, soit la diminution du flux de photons primaires, due à leur recombinaison suite aux effets non-linéaires.

Dans le cas d'un traitement de décapage effectué par plasma sur un objet tel qu'une plaque de silicium monocristalline sur laquelle est déposée une structure microélectronique partiellement protégée par des masques en matière photorésistante, on peut avantageusement appliquer un mouvement ondulatoire à l'objet à traiter dans une direction déterminée, par exemple perpendiculairement à la surface de la plaque de manière à pratiquer un décapage anisotrope. Le degré d'anisotropie dépendra de l'amplitude et de la fréquence du mouvement ondulatoire imposé à la surface à traiter.

Lorsque l'objet à traiter est une feuille en métal, en plastique ou en matière textile, on peut soumettre ladite feuille à l'action simultanée d'un flux de plasma balayant la surface de cette feuille et d'un mouvement vibratoire de la feuille qui intensifie le traitement de nettoyage, de dégraissage, de décapage ou de dépôt de film effectué par le flux de plasma.

Une réalisation semblable et aussi efficace est possible lorsque l'objet à traiter est un fil soit métallique, soit textile, soit polymérique.

Un autre mode de réalisation de la présente invention consiste à générer le plasma simultanément à deux endroits sur la surface d'un objet à traiter de forme asymétrique, par exemple un container de grand volume et de configuration complexe, par deux décharges à haute fréquence sous forme de réseaux ramifiés de filaments de plasma entre deux électrodes capacitaires pourvues d'un mouvement de balayage le long de la surface extérieure de l'objet à traiter.

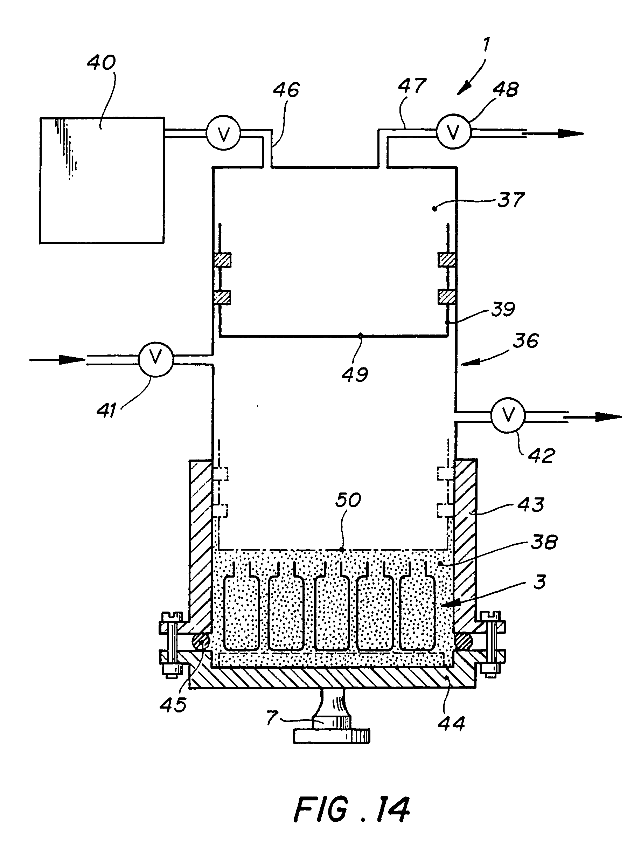

Un mode de génération du plasma qui représente un intérêt pratique important est la génération du plasma par compression adiabatique (isoentrope). Un dispositif de traitement par la génération d'un tel plasma est montré dans la Fig. 14.

Le dispositif de traitement 1 comporte une enceinte 36 comprenant une partie de chambre de piston 37 et une partie de logement des objets à traiter 38, un piston massif 39, un dispositif de compression de gaz 40 muni de moyens de détente rapide, un générateur de vibrations acoustiques 7, un conduit d'entrée de gaz de traitement avec vanne 41 et un conduit d'évacuation de gaz avec vanne 42. La partie de logement des objets 38 comprend une partie de paroi latérale 43, une partie de paroi de fond 44 fixée à la partie de paroi latérale par l'intermédiaire d'un joint hermétique et amortisseur de vibrations 45. Le piston 39 est monté de façon coulissante à l'intérieur de la partie de chambre de piston 37 de l'enceinte 36, la partie de chambre au-dessus du piston pouvant être remplie rapidement par un gaz à haute pression généré par le dispositif de compression de gaz 40 connecté à cette partie de chambre par un conduit 46. Un conduit de sortie 47 avec vanne 48 permet d'évacuer les gaz dans la partie de l'enceinte au dessus du piston quand le piston 39 est remonté. Le conduit d'entrée de sortie 41, 42 permet de remplir la partie de logement des objets avec le gaz de traitement ainsi que de l'évacuer après traitement, et de la remplir de nouveau avec des gaz de traitement.

Quand le piston est en position de point-mort-haut, l'intérieur de l'enceinte est d'abord mise sous vide par une pompe à vide (non illustrée) connectée à la sortie 42, puis remplie d'un gaz de traitement alimenté par la conduite d'entrée 41. Le dispositif de compression 40 comprend un réservoir d'air comprimé connecté à travers une valve actionnable avec la partie de l'enceinte au-dessus du piston. Le piston 39 est projeté vers le bas par l'air comprimé et ne s'arrête qu'en position point-mort-bas 50.

Les dimensions (diamètre et hauteur) de l'enceinte, la pression initiale du gaz de traitement et la pression exercée sur le piston sont calculés de façon que lors de son mouvement du point-mort-haut 49 au point-mort-bas 50, le piston comprime le gaz de traitement suivant la courbe adiabatique de Hugogniot.

Le plasma est généré par compression adiabatique. Il repousse le piston qui retourne dans sa position point-mort-haut 49, le gaz au-dessus du piston étant évacué pendant sa course de bas en haut par le conduit 47. L'avantage de cette forme d'exécution est que le plasma est uniformément généré dans tout le volume de traitement de façon à ce que le traitement soit effectué de manière uniforme sur toutes les faces des objets à traiter se trouvant dans l'enceinte.

La dynamique du processus de compression est calculée de telle manière qu'un plasma de paramètres donnés est formé dans la zone de traitement de l'enceinte, et que des vibrations sont générées par la source extérieure de vibrations 7 fonctionnant de préférence à une des fréquences propres des objets à traiter ou à une multiple d'une des fréquences propres.

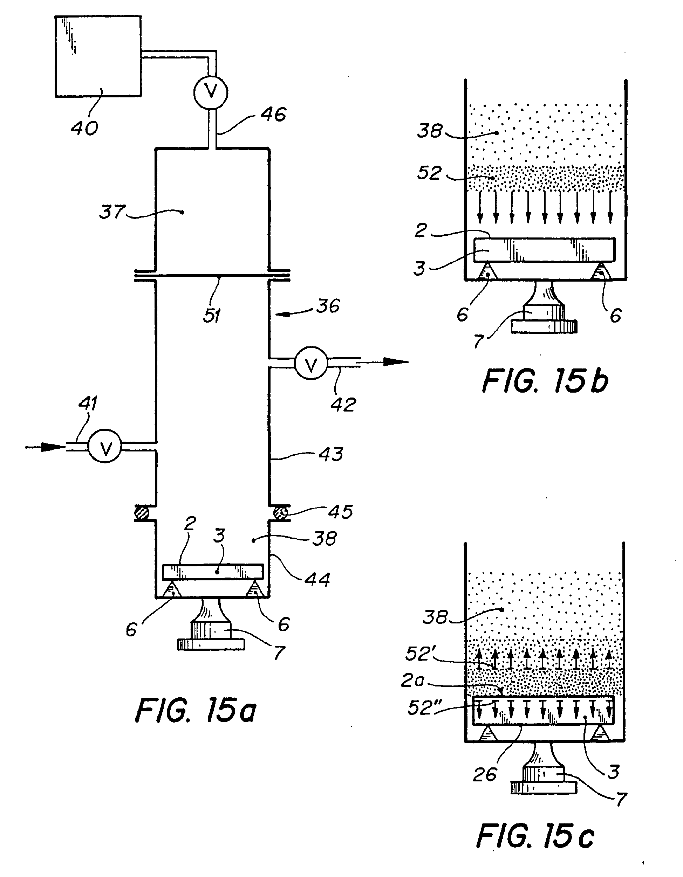

Un autre mode de génération du plasma qui peut être également intéressant en pratique est la génération du plasma par une onde de choc. Un dispositif permettant la génération d'un tel plasma est illustré schématiquement dans les Figures 15a à 15c.

Le dispositif de traitement 1 selon la Fig. 15a comprend une enceinte 36 comprenant une première partie 37 de stockage de gaz comprimé connecté à travers un conduit 46 avec une valve à un dispositif de compression de gaz 40, et une partie de logement des objets à traiter 38 avec un conduit d'entrée de gaz de traitement 41 muni d'une valve et un conduit d'évacuation de gaz de traitement 42 muni d'une valve. La partie de logement des objets à traiter comprend une partie de paroi latérale 43 et une partie de fond 44 montées ensemble par l'intermédiaire d'un joint hermétique absorbeur de vibrations 45. Le dispositif comprend en outre un générateur de vibrations ultrasoniques externe 7 disposé sous la partie de fond 44. Une paroi de séparation amovible 51 peut être disposée de sorte à séparer hermétiquement la partie de stockage de gaz comprimé 37 de la partie de logement des objets à traiter 38.

Au début du procédé de traitement, une pompe à vide connectée au conduit d'évacuation 42 vide la partie 38 de l'enceinte qui est ensuite remplie d'un gaz de traitement alimenté par le conduit d'entrée 41. Le dispositif de compression 40 comprime un gaz de traitement dans la partie de stockage de gaz comprimé 37 jusqu'à une pression (réglable) supérieure à la pression critique de génération d'une onde de choc. Ensuite, on enlève la paroi amovible 51 subitement pour faire communiquer les deux parties de l'enceinte 37, 38.

Les dimensions (diamètre et hauteur) de l'enceinte, la pression initiale du gaz de traitement, la position de la paroi de séparation, la pression du gaz de compression et d'autres paramètres sont calculés de manière à ce que la compression du gaz de traitement derrière l'onde de choc s'effectue selon la courbe adiabatique de Poisson. La dynamique du processus de compression par l'onde de choc incidente et l'onde de choc réfléchie est calculée de manière qu'un plasma de paramètres donnés soit formé dans la zone de l'objet à traiter. L'objet 3 est soumis à l'action plasmochimique du plasma créé derrière l'onde de choc réfléchie 52', celui-ci étant le résultat de la double compression par l'onde incidente 52 et l'onde réfléchie 52'. Une partie de l'énergie de l'onde de choc incidente 52 est absorbée par l'objet à traiter 3, sous forme d'une onde de choc 52" qui se propage à la vitesse du son dans l'objet, qui est bien supérieure à la vitesse du son dans le plasma. L'onde dans l'objet se réfléchit sur la paroi opposée 26 et effectue ainsi un mouvement de va-et-vient qui se dissipe sous forme de vibrations acoustiques.

Ces vibrations de la surface de l'objet à traiter provoquent une intensification des réactions plasmochimiques entre les particules de la surface à traiter 2a et le plasma. On peut augmenter l'amplitude des vibrations par une source de vibrations extérieure 7 émettant par exemple une fréquence proche ou identique à l'une des fréquences propres de l'objet ou d'un multiple de cette fréquence.

La fréquence de cette vibration extérieure peut toutefois être choisie de manière à ne correspondre ni à la fréquence des vibrations de l'onde de choc dans l'objet à traiter, ni à une fréquence propre de l'objet à traiter.

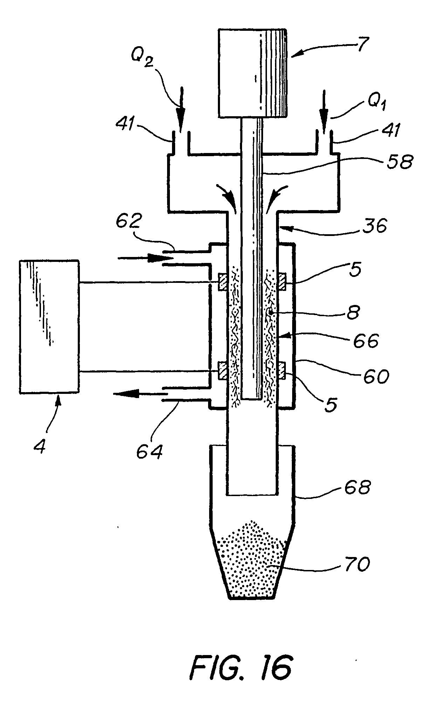

Faisant référence à la Fig. 16, il est également décrit un procédé pour former un plasma dans une enceinte 36 dans laquelle on introduit par des entrées 41 des gaz et des vapeurs $Q_1$, $Q_2$. La décomposition des gaz dans le plasma, forment des clusters et des poudres, notamment des nano-poudres, dont le degré de structuration la forme et la quantité sont déterminés par l'action simultanée du plasma et des vibrations ultrasoniques dans le milieu en question. Ces vibrations sont, par exemple, transmises à l'enceinte par un générateur à ultrasons 7, ou générées dans l'enceinte 36 par des impulsions de courant dans le plasma tel que décrit auparavent, c'est-à-dire dont le front de création de plasma a les caractéristiques décrites en rapport avec la Fig. 5

De cette manière, par exemple, on a produit par décomposition d'hexaméthyldisiloxane en milieu argon+oxygène des nano-poudres de $SiO_2$ sous forme de monocristaux dont la dimension moyenne est d'environ 20 nm avec une dispersion de $\pm$ 20%. La productivité de la méthode a été augmentée de 35 fois, les autres paramètres conservés, en imposant à la décharge électrique haute fréquence (HF) (puissance 45kW, diamètre du flux de plasma : 35mm) une vibration acoustique à la fréquence de 45kHz (puissance 2kW).

Dans le dispositif de la Fig. 16, le générateur à ultrasons 7 comporte un transmetteur d'ultrasons 58 monté coaxialement à l'intérieur de l'enceinte 36, qui est dans cet exemple de forme cylindrique, de sorte que les particules de poudre sont formées et traitées dans l'espace annulaire entre le transmetteur d'ultrasons 58 et la paroi de l'enceinte 36. Le dispositif peut en outre être muni d'un circuit de refroidissement 60 enveloppant une partie de l'enceinte 36 et ayant une entrée 62 et une sortie 64 pour la circulation du liquide de refroidissement. Le plasma 8 est créé dans une partie 66 de l'enceinte autour de laquelle sont placées des électrodes 5 connectées à une source de courant 4, par exemple à haute fréquence, pour la génération du plasma dans le volume de la partie de l'enceinte 66, soit par effet capacitif, soit par effet inductif. Si un générateur de vibrations acoustiques externe est fourni, le plasma peut être créé dans le volume par des moyens conventionnels bien connus. Par contre, en l'absence d'un dispositif de génération de vibrations externes, des vibrations acoustiques peuvent être générées par la création du plasma en impulsions respectant les conditions déjà décrites en relation avec la Fig. 5.

Le dispositif de la Fig. 16 peut également être utilisé pour un traitement de noyaux de poudre, qui peuvent par exemple être introduits avec les mélanges gazeux $Q_1$, $Q_2$, pour former une poudre de grains composites. Le plasma active les atomes et molécules du mélange gazeux qui se mettent en contact avec les noyaux pour former un film atomique ou moléculaire homogène à la périphérie des noyaux. Les vibrations acoustiques font vibrer acoustiquement soit les ions du plasma, soit les noyaux des grains, soit les deux, de sorte qu'il y a un mouvement ondulatoire relatif entre la surface d'un noyau et les ions du plasma qui catalyse le processus de dépôt. La poudre 70 ainsi formée ou fabriquée est captée dans un collecteur 68 disposé sous le tube 36.

Un autre mode de réalisation de la présente invention consiste à imposer une vibration acoustique à un traitement de décapage par plasma. Le corps traité est par exemple, une plaque de silicium monocristalline, recouverte d'une structure, comprenant des masques utilisés de manière standard en microélectronique. Le plasma est par exemple un plasma atmosphérique (voir, par exemple, la publication P. Koulik. Atmospheric Non-Equilibrium Plasma Assisted Surface Technology p.145. CIP 95 published in SFV May 1997). La plaque de silicium est disposée sur un support de manière, d'une part à être soumise au jet de plasma atmosphérique dans lequel sont injectés des gaz décapants tels que le $CF_4$. Le support (et donc la plaque) sont soumis à une vibration ultrasonique perpendiculaire à la surface de la plaque (v = 15kHz, Puissance variable).

L'expérience montre que, lorsque la vibration ultrasonique est appliquée, le décapage se fait de manière anisotrope en ce sens que la vitesse de décapage $v_{||}$ dans la direction parallèle au mouvement vibrationnel (perpendiculaire à la surface de la plaque de silicium) est supérieure à la vitesse de décapage dans la direction perpendiculaire v . Variant la puissance P de la vibration entre 0,1 et 2 kW on est parvenu à obtenir un rapport $v_{||}$ / v variant entre 1,2 et 30. Ce rapport augmente de 1,5 avec l'augmentation de la fréquence de 15 à 45 kHz.

Le procédé de traitement de plasma de la présente invention peut être avantageusement utilisé pour le nettoyage ou le décapage de feuilles ou de fils métalliques. Par exemple, une feuille d'aluminium passant à travers un rideau de plasma peut être nettoyée de la couche de graisse ou d'huile qui la recouvre après son laminage. L'application d'une vibration acoustique intensifie le traitement mentionnée de manière significative. A titre d'exemple, dans une expérience pratique, un nettoyage pratiquement total a été obtenu pour une densité linéaire de puissance de plasma de 1 kW/cm et pour une vitesse de passage de la feuille à travers le rideau de plasma de 3m/sec. En soumettant la feuille d'aluminium à une vibration ultrasonique par l'intermédiaire d'un support sur lequel elle repose lors du traitement (v = 45 kHz, P=0,1kW/cm), on est parvenu à obtenir la même qualité de nettoyage pour une puissance électrique réduite de moitié, soit 0,5kW/cm.

Dans le cas du traitement de la surface intérieure ou extérieure d'un corps creux de forme asymétrique ayant par exemple la forme d'un container de grand volume et de configuration complexe, on peut générer le plasma sous forme de réseau ramifié à deux endroits sur la surface du corps à traiter, par deux décharges à haute fréquence sous forme de réseaux ramifiés de filaments de plasma entre deux électrodes capacitaires pourvues d'un mouvement de balayage le long de la surface extérieure du corps.

A titre d'exemple, dans une expérience pratique on a recouvert de cette manière à l'aide de décharges HF (13,56 MHz) la surface intérieure d'un réservoir à carburant monocouche en polyéthylène. Les décharges, de plasma, sous forme de réseaux ramifiés de filaments, étaient créées dans un mélange gazeux d'argon, d'oxygène et de HMDS. La puissance moyenne de la décharge était de 5 kW. En 60 secondes la surface intérieure du container a été recouverte d'un film de $SiO_2$ de 0,1 $\mu$m d'épaisseur, représentant une barrière relative aux molécules d'hydrocarbures, de mille (Barrier Improvement Factor BIF=1000).

Des exemples non-limitatifs de mise en oeuvre du procédé selon l'invention sont donnés ci-après.


Exemple 1:

Dépôt d'un film d'oxyde de silicium sur la surface intérieure d'une bouteille monocouche PET (0,5l), par méthode HF :

> Produits de base utilisé consécutivement et avec répétition : Ar, $O_2$,
> Hexaméthyldisiloxane (HDMS), $CH_4$
> Tension maximum de la source de courant : 21 kV
> Amplitude du courant de la décharge : 10 A
> $t_1 = 3\mu$s
> $t_2 = 300\mu$s
> $t_3 = 40$ms
> Durée du traitement : 30 sec.
> Matériau principal de la barrière : $SiO_x$ (x = 1,96)
> Epaisseur de la barrière 18-19 nm (180-190 Å)
> Niveau de barrière à l'oxygène (volume d'oxygène qui diffuse à travers la paroi de la bouteille par jour) :

>> avant traitement : $0,06$cm$^3$/bout.jour
>> après traitement : 0,0001 cm3/bout.jour

> Coefficient relatif de barrière par rapport à l'Oxygène: BIF*~ 60
> Coefficient de barrière par rapport au $CO_2$ : BIF*~ 15
> *: BIF : Barrier Improvement Factor

Exemple 2 :

Dépôt d'un film d'oxyde de silicium sur un tube en polyéthylène monocouche (200ml).

Produits de base utilisé consécutivement : Ar, $O_2$, HDMS, TEOS, $CH_4$
Tension maximum de la source de courant : 10 kV
Amplitude du courant de la décharge : 8 A
$t_1 = 2\mu s$
$t_2 = 200\mu s$
$t_3 = 10ms$
Durée du traitement : 30 sec.
Matériau principal de la barrière : $SiO_x$ (x = 1,95)
Epaisseur de la barrière : 25 nm (250 Å)
Niveau de barrière à l'oxygène :

avant traitement intérieur : $0,7cm^3$/tube.jour
après traitement intérieur : $0,005cm^3$/tube.jour
après traitement extérieur : $0,1cm^3$/tube.jour
après traitement sur les deux faces : $0,002cm^3$/tube.jour

Coefficient de barrière à l'oxygène :

après traitement intérieur : BIF ~ 140
après traitement extérieur : BIF ~ 7
après traitement sur les deux faces : BIF ~ 350

Exemple 3.

Un traitement de dépôt de film ($SiO_2$) par décomposition de HDMS dans un plasma à pression atmosphérique a été effectué à l'intérieur d'un récipient (bouteilles PET) dans les conditions suivantes :

- Fréquence (v) des ondulations imposées (source extérieure d'ultrasons de différentes densité d'énergie E) au récipient pendant le traitement :

$v = 3.10^1$ kHz.

- Amplitude (I) des ondulations (mesurée par une caméra à haute vitesse : $10^6$ cadres/sec) :

$$I = 1/v \cdot \sqrt{(E/\rho)}$$

où $\rho$ est la densité du matériau traité.

- Croissance de la température ($\Delta T$) de la paroi du récipient, par exemple suite au traitement par plasma atmosphérique (mesurée à l'aide d'un pyromètre infrarouge) :

$$\Delta T = 10K.$$

Dans ces conditions, la densité d'énergie (E) du mouvement ondulatoire est :

$$E_{ond} = \frac{1}{2} \rho^2 v^2$$

- La densité de l'énergie thermique (ET) communiquée au corps par le plasma et correspondant à une augmentation

de température ∆T de 10K est :

$$E_T = \rho c \Delta T$$

où c est la capacité thermique du matériau.

- Le rapport (R) des deux grandeurs est : $R = E_{ond}/E_T = \frac{1}{2} \, |^2V^2 / c\Delta T$.

Suivant les régimes ondulatoires (I) imposés au processus nous avons :

Tableau N°1 :

| $I_{(M)}$ | R | Épaisseur ∆ de la couche obtenue (mesurée par ellipsométrie) (M) |
|---|---|---|
| $10^{-4}$ | $1,8.10^{-3}$ | Non mesurable |
| $2.10^{-4}$ | $8.10^{-3}$ | ~ $1.10^{-8}$ |
| $3.10^{-4}$ | $1,6.10^{-2}$ | $9.10^{-8}$ |
| $6.10^{-4}$ | $6.10^{-2}$ | $2.10^{-7}$ |

Le résultat de cette expérience permet de conclure que, dans le cas du traitement de dépôt de film par plasma atmosphérique, la densité d'énergie du mouvement ondulatoire est supérieure à environ un centième de la densité d'énergie thermique communiquée au corps traité dans ce cas par le plasma. De manière générale, cela implique que l'imposition du mouvement ondulatoire ne devient efficace que quand son intensité est telle que la densité d'énergie de ce mouvement devient significative par rapport à l'augmentation de l'énergie thermique du corps traité, celle-ci étant proportionnelle à l'augmentation de sa température avant et/ou pendant le traitement. Cette énergie thermique peut être communiquée au corps traité suite à un échange thermique avec une source de chaleur. En particulier, la source de chaleur peut être le plasma lui-même.

Dans cet exemple, le rapport minimum R des densités d'énergies pour lequel le mouvement ondulatoire devient efficace s'est avéré être environ un centième. Vu le caractère complexe de l'interaction entre la surface, d'une part ondulante, et d'autre part échauffée, avec le plasma, il est possible que ce rapport soit un centième pour le processus concret analysé, (dépôt de film SiO$_2$) mais différent pour un autre processus, par exemple, le décapage, l'activation, ou la stérilisation. De manière générale, il faut donc retenir le mot "significatif" qui veut dire que la densité d'énergie du mouvement ondulatoire imposé doit être une fraction significative de la densité d'énergie thermique, probablement au-dessus du millième. L'exemple donné montre que la valeur de cette fraction existe et est à déterminer dans chaque cas particulier.

Exemple 4.

Lors du traitement de dépôt de film mentionné dans l'exemple 3, l'épaisseur de la couche limite par rapport à la diffusion des particules (Si) vers la paroi à traiter a été estimée en partant des estimations de la température moyenne du plasma sur la base des données spectroscopiques mentionnées dans l'article : A. Kakliougin, P. Koulik, et al., "HF Atmospheric Plasma Sterilization of Dielectric Containers Inside Surfaces" CIP 2001, publié par SFV; Dépôt légal 1ère édition mai 2001 p. 28. Selon ces estimations la vitesse thermique ($V_T$) des particules diffusantes a été estimée à $V_T \sim 10^3$ m/s. La concentration $n_r / n_{pl}$ des particules de Si diffusantes a été mesurée par mesureurs de débit et est égale à $10^{-5}$ (rapport de la densité des particules de Si à la densité totale des particules de plasma), et la section efficace des particules diffusantes a été évaluée à $10^{-18}$ m$^2$ selon Braun (S. Braun, Basic Processes in Gas Discharges. Cambridge, MTI, 12, 1959).

La durée du traitement par plasma a été de ∆T = 30sec.

Dans ces conditions, l'épaisseur δ de la couche limite pour les régimes décrits dans l'exemple précédent est calculée suivant la formule : $\delta = v_T \cdot n_r/n_{pl} . \Delta T/Q \Delta n_{sol}$

où $n_{sol}$ est la densité des particules de la couche déposée (~ $10^{28}$m$^{-3}$) dont l'épaisseur est ∆, et Q est la section efficace des particules diffusantes.

Suivant les régimes ondulatoires imposés au processus, nous avons :

Tableau N°2 :

| l(m) | l/δ | Δ(m) |
|---|---|---|
| 10 | 0,3 | Non mesurable |
| $2.10^{-4}$ | 0,7 | $1.10^{-8}$ |
| $3.10^{-4}$ | 1 | $9.10^{-8}$ |
| $6.10^{-4}$ | 2 | $10.10^{-8}$ |

Ces résultats montrent que c'est quand l'amplitude du mouvement ondulatoire est supérieure à l'épaisseur de la couche limite entre le plasma et le corps traité qu'on obtient, dans les conditions de l'expérience, une couche d'oxyde de silicium d'épaisseur mesurable (c'est-à-dire que le procédé est efficace).

Ce résultat implique que le mouvement ondulatoire imposé à la surface traitée n'est efficace que lorsqu'il provoque une turbulisation du plasma, celle-ci intensifiant substantiellement l'échange moléculaire entre le plasma et la surface traitée, s'accompagnant, par exemple, d'un dépôt de film, comme dans l'exemple mentionné.


**Revendications**

1. Procédé de traitement par plasma d'une surface à traiter d'un objet ou de particules, comprenant la création d'un plasma et l'application du plasma contre la surface à traiter, **caractérisé en ce que** l'on excite la surface à traiter pour créer un mouvement ondulatoire relatif entre le plasma et la surface à traiter, de l'énergie pour l'excitation de la surface à traiter provenant du procédé de création du plasma.

2. Procédé selon la revendication 1, **caractérisé en ce que** l'on excite la surface à traiter ou que l'on fait vibrer acoustiquement le plasma au moyen d'un générateur de vibrations externe, en combinaison avec la source d'énergie provenant du procédé de création du plasma.

3. Procédé selon la revendication 2, **caractérisé en ce que** l'on génère des ultrasons.

4. Procédé selon la revendication 2 ou 3, **caractérisé en ce que** l'on ajuste la fréquence de vibrations du générateur à une fréquence proche ou identique à une des fréquences propres de l'objet à traiter.

5. Procédé selon l'une des revendications précédentes, **caractérisé en ce que** l'on mesure la fréquence et l'amplitude des vibrations de l'objet à traiter au moyen d'un capteur de vibrations, pour identifier les fréquences propres de l'objet à traiter et/ou pour contrôler l'excitation de la surface à traiter.

6. Procédé selon l'une des revendications précédentes, **caractérisé en ce que** l'on excite la surface à traiter ou que l'on fait vibrer le plasma par une onde de choc produite lors de la création du plasma.

7. Procédé selon l'une des revendications précédentes, **caractérisé en ce que** l'on crée le plasma dans un milieu gazeux comprenant un gaz de traitement pouvant être activé par voie plasmochimique, le gaz de traitement étant en contact avec la surface à traiter.

8. Procédé selon l'une des revendications précédentes, **caractérisé en ce que** le plasma est généré par impulsions, la durée de vie du plasma généré étant supérieure à la période du mouvement ondulatoire.

9. Procédé selon la revendication 8, **caractérisé en ce que** l'impulsion de plasma est générée par une compression essentiellement adiabatique et isoentrope d'un milieu gazeux comprenant un gaz de traitement plasmochimiquement activable.

10. Procédé selon la revendication 8, **caractérisé en ce que** les impulsions sont générées par des ondes de choc incidentes et réfléchies de la surface à traiter.

11. Procédé selon la revendication 8, **caractérisé en ce que** les impulsions sont générées par des impulsions de courant électrique unipolaire ou à haute fréquence.

**12.** Procédé selon la revendication précédente, **caractérisé en ce que** la durée ($t_1$) de croissance de l'amplitude du courant électrique d'une impulsion est inférieure au rapport (d/v) du diamètre (d) d'un canal ou filament de plasma créé à la vitesse du son (v) dans le milieu gazeux entourant le canal de plasma.

**13.** Procédé selon la revendication 11 ou 12, **caractérisé en ce que** des ondes de choc sonique sont créées par un claquage électrique pendant la création d'un canal ou filament de plasma.

**14.** Procédé selon l'une des revendications 11 à 13, **caractérisé en ce que** la durée ($t_2$) d'une impulsion électrique est ajustée pour éviter un échauffement superficiel de la surface à traiter au dessus de la température critique d'instabilité du matériau.

**15.** Procédé selon l'une des revendications 11 à 14, **caractérisé en ce que** la durée entre impulsions ($t_3$) est plus grande que le temps de post-décharge ($t_4$) pour permettre à une majorité des particules de la surface à traiter d'atteindre un état stable ou métastable.

**16.** Procédé selon l'une des revendications 11 à 15, **caractérisé en ce que** l'on crée un plasma sous forme d'un réseau ramifié de filaments de plasma générant des ondes de choc.

**17.** Procédé selon l'une des revendications 11 à 16, **caractérisé en ce que** l'on déplace le plasma sur la surface à traiter par un mouvement relatif entre une électrode et l'objet à traiter et/ou par un champ magnétique en déplacement et/ou par un effet hydrodynamique d'un gaz de traitement dans lequel le plasma est créé.

**18.** Procédé selon la revendication précédente, **caractérisé en ce que** la durée de l'impulsion ($t_2$) est inférieure au rapport de la largeur d'un filament de plasma appliqué contre la surface à traiter et la vitesse de déplacement de la surface à traiter par rapport au plasma.

**19.** Procédé selon l'une des revendications 11 à 18, **caractérisé en ce que** l'on crée et applique simultanement une pluralité de faisceaux de plasma ramifiés distribués sur la surface à traiter.

**20.** Procédé selon l'une des revendications précédentes, **caractérisé en ce que** l'on alimente le plasma par des gaz de traitement de compositions différentes successivement pour des traitements successifs différents de la surface à traiter.

**21.** Procédé selon la revendication précédente, **caractérisé en ce que** les gaz de traitement comprennent l'argon, des vapeurs organo-métalliques tels que du silicium et de l'oxygène, et des hydrocarbures.

**22.** Procédé selon l'une des revendications 2 à 4 dans le cas du traitement de bouteilles ou d'autres récipients profonds, **caractérisé en ce que** l'on génère des vibrations sous un fond du récipient opposé à un goulot de manière à augmenter l'efficacité du traitement sur le fond.

**23.** Procédé selon l'une des revendications 2 à 5 **caractérisé en ce que** l'on effectue un décapage anisotropique de la surface à traiter par la génération de vibrations dans une direction déterminée par rapport à la surface à traiter.

**24.** Procédé selon la revendication précédente dans le cas du traitement de décapage d'une surface d'un semiconducteur, **caractérisé en ce que** l'on génère des vibrations qui se déplacent dans une direction essentiellement perpendiculaire à ladite surface.

**25.** Procédé selon l'une des revendications 1 à 15, **caractérisé en ce que** le traitement par plasma est un traitement de décapage et que le mouvement ondulatoire de la surface à traiter, telle que la surface d'une plaque de silicium monocristalline sur laquelle est déposée une structure microélectronique partiellement protégée par des masques en matière photorésistante, est effectué dans une direction déterminée, tel que perpendiculairement à la surface de la plaque, ce qui permet de pratiquer un traitement de décapage anisotrope, le degré d'anisotropie dépendant de l'amplitude et de la fréquence du mouvement ondulatoire imposé à la surface à traiter.

**26.** Procédé selon l'une des revendications 1 à 15, **caractérisé en ce que** le corps à traiter est une feuille de métal ou en matière plastique ou en matériau textile soumise à l'action simultanée d'un flux de plasma et d'un mouvement vibratoire du support fixant la position de la feuille par rapport au flux de plasma.

**27.** Procédé selon l'une des revendications 1 à 15, **caractérisé en ce que** le plasma est généré simultanément à deux endroits sur la surface intérieure d'un corps à traiter de grand volume et de configuration complexe, par deux décharges à haute fréquence sous forme de réseaux ramifiés de filaments de plasma entre deux électrodes capacitaires pourvues d'un mouvement de balayage le long de la surface extérieure d'un corps à traiter.

**28.** Procédé selon l'une des revendications précédentes, **caractérisé en ce que** la densité d'énergie communiquée à l'objet à traiter par mouvement ondulatoire est supérieure à un pour mille de l'augmentation de densité d'énergie thermique communiquée à l'objet avant ou lors du traitement.

**29.** Procédé selon l'une des revendications précédentes, **caractérisé en ce que** la densité d'énergie communiquée à l'objet à traiter par mouvement ondulatoire est supérieure à un pour cent de l'augmentation de densité d'énergie thermique communiquée à l'objet avant ou lors du traitement.

**30.** Procédé selon l'une des revendications précédentes, **caractérisé en ce que** l'amplitude du mouvement ondulatoire est sensiblement supérieure à l'épaisseur de la couche limite qui s'établit entre le plasma et la surface de l'objet lors du traitement par plasma, cet effet s'accompagnant d'une turbulisation du plasma.

**31.** Dispositif pour la mise en oeuvre d'un procédé de traitement de surface selon l'une des revendications 1 à 30, **caractérisé en ce qu'**il comprend un dispositif de génération de plasma apte à générer des impulsions de plasma ayant une durée ($t_1$) de croissance d'amplitude du courant électrique d'une impulsion inférieure au rapport (d/v) du diamètre (d) d'un canal ou filament du plasma créé à la vitesse du son (*v*) dans le milieu gazeux entourant le canal du plasma, et un capteur de vibrations disposé de manière à mesurer les vibrations émises par l'objet à traiter lors du procédé de traitement de surface par plasma.

**32.** Dispositif selon la revendication 31, **caractérisé en ce que** le dispositif de génération de plasma est apte à générer des impulsions de plasma ayant une durée ($t_1$) de croissance d'amplitude de courant électrique d'une impulsion inférieure ou égale à $3 \times 10^{-6}$s.

**33.** Dispositif selon la revendication 31, **caractérisé en ce qu'**il comprend un système laser pouvant émettre un rayon laser à travers une paroi de l'objet à traiter et comportant un capteur de rayons lasers réfléchis ou traversant la paroi pour détecter la quantité de photons émis par effets non-linéaires lors du passage du rayon laser à travers la surface traitée, ou la diminution de flux de photons primaires due à leur recombinaisons suite aux effets non-linéaires.

**34.** Dispositif selon l'une des revendications 31 à 33, **caractérisé en ce qu'**il comprend un dispositif de refroidissement de l'objet à traiter par ecoulement ou projection d'un fluide sur l'objet à traiter.

**35.** Dispositif selon la revendication précédente, **caractérisé en ce que** le dispositif de refroidissement souffle de l'air ou un autre gaz sur l'objet à traiter pendant ou juste après l'application du plasma contre la surface à traiter.

**36.** Dispositif selon l'une des revendications 31 à 35, **caractérisé en ce que** le dispositif de génération de plasma comprend une électrode pouvant être déplacée par rapport à l'objet à traiter.

**37.** Dispositif selon l'une des revendications 31, 32, 33, 35 ou 36, **caractérisé en ce que** le dispositif de génération de plasma comporte une électrode comprenant un conduit d'alimentation de gaz.

**38.** Dispositif selon la revendication précédente, **caractérisé en ce que** l'électrode comprend une pluralité de conduits d'alimentation de gaz.

**39.** Dispositif selon l'une des deux revendications précédentes, **caractérisé en ce que** l'électrode comprend une tête d'alimentation rotative sur laquelle sont montés le ou les conduits d'alimentation de gaz de traitement pour le traitement de récipients essentiellement axisymétriques.

**40.** Dispositif selon l'une des revendications 36 à 39, **caractérisé en ce que** l'angle d'inclinaison des conduits d'alimentation de gaz de traitement est réglable de manière à pouvoir ajuster l'angle d'incidence du gaz de traitement par rapport à la surface à traiter.

**41.** Dispositif selon l'une des revendications 36 à 39, **caractérisé en ce que** les conduits d'alimentation de gaz de traitement pour le traitement de récipients essentiellement axisymétriques sont essentiellement disposés sous forme d'un cône pour la distribution du gaz de traitement de façon essentiellement axisymétrique.

**42.** Dispositif selon la revendication 31, **caractérisé en ce qu'**il comporte un dispositif de génération de plasma par décharge électrique comprenant une électrode sous forme d'un jet de liquide conducteur dirigeable contre une paroi de l'objet à traiter du côté opposé à la surface à traiter.

**43.** Dispositif selon l'une des revendications 31 à 42, **caractérisé en ce qu'**il comprend des moyens d'enregistrement et de contrôle des paramètres du plasma pendant le traitement.

**44.** Dispositif selon la revendication précédente, **caractérisé en ce que** les moyens d'enregistrement et de contrôle des paramètres sont aptes à enregistrer et/ou contrôler le front de développement de l'impulsion de la tension électrique et/ou du courant électrique.

**45.** Dispositif selon la revendication 43 ou 44, **caractérisé en ce que** les moyens d'enregistrement et de contrôle des paramètres sont aptes à enregistrer et/ou contrôler l'amplitude et la durée des impulsions ainsi que la pause entre les impulsions.

**46.** Dispositif selon la revendication 43, 44 ou 45, **caractérisé en ce que** les moyens d'enregistrement et de contrôle des paramètres sont aptes à enregistrer et/ou contrôler l'amplitude et la fréquence des vibrations acoustiques émises par l'objet à traiter.

**47.** Dispositif selon la revendication 43, 44, 45 ou 46, **caractérisé en ce que** les moyens d'enregistrement et de contrôle des paramètres sont aptes à enregistrer et/ou contrôler la température de l'objet à traiter.

**Claims**

**1.** Plasma treatment process of an object's surface to be treated, comprising the creation of a plasma, the application of the plasma to the surface to be treated, **characterized in that** the surface to be treated is excited so that a relative undulating movement between the surface to be treated and plasma is created, energy for the excitation of the surface to be treated supplied by the plasma creation process.

**2.** Process according to claim 1, **characterized in that** the surface to be treated is excited, or the plasma is acoustically vibrated by means of an external vibration generator, in combination with the energy source supplied by the plasma creation process.

**3.** Process according to claim 2, **characterized in that** ultrasound is generated.

**4.** Process according to claim 2 or 3, wherein the vibration frequency of the generator is adjusted to a frequency close to or identical with one of the eigenfrequencies of the object to be treated.

**5.** Process according to any preceding claim, **characterized in that** the frequency and amplitude of the vibrations of the object to be treated are measured by means of a vibration sensor in order to identify the eigenfrequencies of the object to be treated and/or to control the excitation of the surface to be treated.

**6.** Process according to any preceding claim, **characterized in that** the surface to be treated is excited by a shock wave produced during creation of the plasma.

**7.** Process according to any preceding claim, **characterized in that** the plasma is created in a gaseous medium comprising a process gas that can be activated plasma-chemically, the process gas being in contact with the surface to be treated.

**8.** Process according to any preceding claim, **characterized in that** the plasma is generated by pulses, the lifetime of the plasma generated being longer than the period of wave motion of the surface to be treated.

**9.** Process according to claim 8, **characterized in that** the plasma pulse is generated by an essentially adiabatic and isentropic compression of a gaseous medium comprising a process gas that can be activated plasma-chemically.

10. Process according to claim 8, **characterized in that** the pulses are generated by incident shock waves and shock waves reflected from the surface to be treated.

11. Process according to claim 8, **characterized in that** the pulses are generated by unipolar or high-frequency electrical current pulses.

12. Process according to the preceding claim, **characterized in that** the rise time $(t_1)$ of the electric current amplitude of a pulse is shorter than medium the ratio (d/v) of diameter (d) of the plasma channel or filament created to the speed of sound (v) in the gaseous surrounding the plasma channel.

13. Process according to claim 11 or 12, **characterized in that** sonic shock waves are created by an electric breakdown during the creation of a plasma channel or filament.

14. Process according to claims 11 to 13, **characterized in that** the length $(t_2)$ of an electric pulse is adjusted so as to avoid superficial heating of the surface to be treated, above the critical temperature of instability of the material.

15. Process according to one of claims 11 to 14, **characterized in that** the interval between pulses $(t_3)$ is longer than the post-discharge time $(t_4)$ in order to allow a majority of the particles of the surface to be treated, to attain a stable or metastable state.

16. Process according to one of claims 11 to 15, **characterized in that** a plasma is created in the form of a branched plasma filament network generating shock waves.

17. Process according to one of claims 11 to 16, **characterized in that** the plasma is moved over the surface to be treated, by a relative motion between an electrode and the object to be treated and/or by a magnetic field in motion and/or by a hydrodynamic effect of a process gas in which the plasma is created.

18. Process according to the preceding claim, **characterized in that** the pulse length $(t_2)$ is inferior to the ratio between the width of a plasma filament applied to the surface to be treated, and the velocity of motion of the surface to be treated relative to the plasma.

19. Process according to one of claims 11 to 18, **characterized in that** a plurality of ramified plasma branches distributed over the surface to be treated are simultaneously created and applied.

20. Process according to one of the preceding claims, **characterized in that** the plasma is fed successively with process gases having different compositions, for different successive treatments of the surface to be treated.

21. Process according to the preceding claim, **characterized in that** the process gases include argon, organometallic vapors such as those of silicon and oxygen, and hydrocarbons.

22. Process according to one of claims 2 to 4 in cases of treatment of bottles or other deep containers, **characterized in that** vibrations are generated underneath a container bottom opposite to a neck so as to enhance the treatment efficiency on the bottom.

23. Process according to one of claims 2 to 5, **characterized in that** an anisotropic etching of the surface to be treated is executed by the generation of vibrations in a particular direction relative to the surface to be treated.

24. Process according to the preceding claim in the case of etching treatment of a semiconductor surface, wherein vibrations are executed moving in a direction essentially perpendicular to said surface.

25. Process according to one of claims 1 to 15, **characterized in that** the plasma treatment is en etching treatment, and the undulating movement of the surface to be treated, such as a surface of a monocrystalline silicon wafer on which a microelectronic structure is deposited and partially protected by masks in photoresist material, is effected in a specific direction, such as perpendicularly to the surface of the wafer, which enables an isotropic etching treatment to be performed, the degree of anisotropy depending on the amplitude and the frequency of the undulating movement applied on the surface to be treated.

26. Process according to one of claims 1 to 15, **characterized in that** the body to be treated is a sheet of metal or plastic or textile subject to the simultaneous action of a plasma flux and a vibration movement of the support that fixes the position of the sheet in relation to the plasma flux.

27. Process according to one of claims 1 to 15, **characterized in that** the plasma is generated simultaneously on two positions of the interior surface of a body to be treated of large volume and complex configuration, by two high frequency discharges in the form of networks of ramified filaments of plasma between to capacitive electrodes provided with a sweeping movement along the external surface of the body to be treated.

28. Process according to one of the preceding claims, **characterized in that** the energy density communicates to the object to be treated by undulating movement is superior to one per thousand of the increase of thermal energy density communicated to the object before or after treatment.

29. Process according to one of the preceding claims, **characterized in that** the energy density communicated to the object to be treated by undulating movement is superior to one per cent of the increase of thermal energy density communicated to the object before or after treatment.

30. Process according to one of the preceding claims, **characterized in that** the amplitude of the undulating movement is substantially superior to the thickness of the boundary layer that is formed between the plasma and the surface of the object during plasma treatment, this effect being accompanied by a turbulent plasma.

31. Device for the realization of a surface treatment process according to one of claims 1 to 30, **characterized in that** it comprises a device for plasma generation able to manage pulses of plasma having a rise time $(t_1)$ of the electric current amplitude of a pulse is shorter than the ratio $(d/v)$ of diameter $(d)$ of the plasma channel or filament created to the speed of sound $(v)$ in the gaseous medium surrounding the plasma channel, and a vibration pickup arranged so as to measure the vibrations emitted by the object to be treated, during the plasma surface treatment process.

32. Device according to claim 31, **characterized in that** the device for plasma generation is able to generate pulses of plasma having a rise time $(t_1)$ of the electric current amplitude of a pulse shorter than or equal to $3 \times 10^{-6}$s.

33. Device according to claim 31, **characterized in that** a laser system that can emit a laser beam across a wall of the object to be treated and includes a sensor for the reflected laser beams or laser beams crossing the wall in order to detect the number of photons emitted by non-linear effects during passage of the laser beam across the surface treated, or the decrease in the flux of primary photons caused by their recombination due to non-linear effects.

34. Device according to one of claims 31 to 33, **characterized in that** it comprises a device for cooling the object to be treated, by a flow or projection of a liquid over the object to be treated.

35. Device according to the preceding claim, **characterized in that** the cooling device blows air or another gas over the object to be treated, during or just after plasma application to the surface to be treated.

36. Device according to one of claims 31 to 35, **characterized in that** the device for plasma generation comprises an electrode that can be moved relative to the object to be treated.

37. Device according to one of claims 31, 32, 33, 35 or 36, **characterized in that** the device for plasma generation includes an electrode comprising a duct for gas feed.

38. Device according to the preceding claim, **characterized in that** the electrode comprises a plurality of gas feed ducts.

39. Device according to one of the two preceding claims, **characterized in that** the electrode comprises a rotating feeding head onto which the duct or ducts of process gas supply for the treatment of essentially axisymmetric containers are mounted.

40. Device according to one of claims 36 to 39, **characterized in that** the angle of inclination of the process gas supply ducts is adjustable so that the angle of incidence of the process gas can be adjusted relative to the surface to be treated.

41. Device according to one of claims 36 to 39, **characterized in that** the process gas supply ducts for the treatment of essentially axisymmetric containers are essentially arranged in the form of a cone for distributing the process gas in an essentially axisymmetric manner.

42. Device according to claim 31, **characterized in that** a device for plasma generation by electric discharge with an electrode in the form of a conducting liquid jet that can be directed against one wall of the object to be treated, on the side opposite to the surface to be treated.

43. Device according to one of claims 31 to 42, **characterized in that** it comprises means for recording and checking the plasma parameters during the treatment.

44. Device according to the preceding claim, **characterized in that** the means for recording and checking the parameters are able to record and/or check the rising flank of the electric voltage and/or electric current pulse.

45. Device according to claim 43 or 44, **characterized in that** the means for recording and checking the parameters are able to record and/or check the amplitude and length of the pulses as well as of the pause between pulses.

46. Device according to 43, 44 or 45, **characterized in that** the means for recording and checking the parameters are able to record and/or check the amplitude and frequency of the acoustic vibrations emitted by the object to be treated.

47. Device according to claim 43, 44, 45 or 46, **characterized in that** the means for recording and checking the parameters are able to record and/or check the temperature of the object to be treated.

**Patentansprüche**

1. Verfahren zur Plasmabehandlung einer zu behandelnden Oberfläche von Gegenständen oder Teilchen, die Erzeugung eines Plasmas und das Anlegen des Plasmas an die zu behandelnde Oberfläche umfassend und **dadurch gekennzeichnet, dass** die zu behandelnde Oberfläche angeregt wird, um eine wellenförmige Relativbewegung zwischen dem Plasma und der zu behandelnden Oberfläche zu erzeugen, wobei die Energie für die Anregung der zu behandelnden Oberfläche aus dem Verfahren zur Erzeugung des Plasmas stammt.

2. Verfahren nach Anspruch 1, **dadurch gekennzeichnet, dass** mittels eines externen Schwingungsgenerators in Kombination mit der Quelle der vom Verfahren zur Erzeugung des Plasmas stammenden Energie die zu behandelnde Oberfläche angeregt oder das Plasma in akustische Schwingungen versetzt wird.

3. Verfahren nach Anspruch 2, **dadurch gekennzeichnet, dass** Ultraschall erzeugt wird.

4. Verfahren nach Anspruch 2 oder 3, **dadurch gekennzeichnet, dass** die Schwingungsfrequenz des Generators auf eine Frequenz eingestellt wird, die einer der Eigenfrequenzen des zu behandelnden Gegenstandes nahe oder damit identisch ist.

5. Verfahren nach einem der vorangehenden Ansprüche, **dadurch gekennzeichnet, dass** die Frequenz und Amplitude der Schwingungen des zu behandelnden Gegenstandes mittels eines Schwingungsfühlers gemessen werden, um die Eigenfrequenzen des zu behandelnden Gegenstandes zu identifizieren und/oder die Anregung der zu behandelnden Oberfläche zu kontrollieren.

6. Verfahren nach einem der vorangehenden Ansprüche, **dadurch gekennzeichnet, dass** eine während der Erzeugung des Plasmas erzeugte Stosswelle verwendet wird, um die zu behandelnde Oberfläche anzuregen oder das Plasma in Schwingungen zu versetzen.

7. Verfahren nach einem der vorangehenden Ansprüche, **dadurch gekennzeichnet, dass** das Plasma in einem Gasmedium erzeugt wird, das ein Behandlungsgas umfasst, das plasmachemisch aktiviert werden kann, wobei das Behandlungsgas mit der zu behandelnden Oberfläche in Berührung steht.

8. Verfahren nach einem der vorangehenden Ansprüche, **dadurch gekennzeichnet, dass** das Plasma durch Impulse erzeugt wird, wobei die Lebensdauer des erzeugten Plasmas länger als die Schwingungsdauer der Wellenbewegung ist.

9. Verfahren nach Anspruch 8, **dadurch gekennzeichnet, dass** der Plasmaimpuls durch eine im Wesentlichen adiabatische und isentropische Verdichtung eines Gasmediums erzeugt wird, das ein plasmachemisch aktivierbares Behandlungsgas umfasst.

**10.** Verfahren nach Anspruch 8, **dadurch gekennzeichnet, dass** die Impulse durch Stosswellen erzeugt werden, die auf die zu behandelnde Oberfläche auftreffen und von ihr zurückgeworfen werden.

**11.** Verfahren nach Anspruch 8, **dadurch gekennzeichnet, dass** die Impulse durch unipolare oder hochfrequente elektrische Stromimpulse erzeugt werden.

**12.** Verfahren nach dem vorangehenden Anspruch, **dadurch gekennzeichnet, dass** die Anstiegszeit ($t_1$) der Amplitude des elektrischen Stromes eines Impulses kleiner als das Verhältnis (d/v) des Durchmessers (d) eines Kanals oder Fadens des erzeugten Plasmas zur Schallgeschwindigkeit (v) in dem den Plasmakanal umgebenden Gasmedium ist.

**13.** Verfahren nach Anspruch 11 oder 12, **dadurch gekennzeichnet, dass** die Schall-Stosswellen durch einen elektrischen Durchschlag während der Erzeugung eines Plasmakanals oder -fadens erzeugt werden.

**14.** Verfahren nach einem der Ansprüche 11 bis 13, **dadurch gekennzeichnet, dass** die Dauer ($t_2$) eines elektrischen Impulses so eingestellt wird, dass eine oberflächliche Erwärmung der zu behandelnden Oberfläche über die kritische Temperatur der Instabilität des Materials vermieden wird.

**15.** Verfahren nach einem der Ansprüche 11 bis 14, **dadurch gekennzeichnet, dass** die Zeit zwischen Impulsen ($t_3$) länger als die Zeit der Nachentladung ($t_4$) ist, um zu ermöglichen, dass eine Mehrheit der Teilchen der zu behandelnden Oberfläche einen stabilen oder metastabilen Zustand erreicht.

**16.** Verfahren nach einem der Ansprüche 11 bis 15, **dadurch gekennzeichnet, dass** ein Plasma in der Gestalt eines verzweigten Netzes von Plasmafäden erzeugt wird, die ihrerseits Stosswellen erzeugen.

**17.** Verfahren nach einem der Ansprüche 11 bis 16, **dadurch gekennzeichnet, dass** das Plasma auf der zu behandelnden Oberfläche durch eine Relativbewegung zwischen einer Elektrode und dem zu behandelnden Gegenstand und/oder durch ein bewegtes Magnetfeld und/oder durch einen hydrodynamischen Effekt eines Behandlungsgases, in dem das Plasma erzeugt wird, verschoben wird.

**18.** Verfahren nach dem vorangehenden Anspruch, **dadurch gekennzeichnet, dass** die Impulsdauer ($t_2$) kleiner als das Verhältnis der Breite eines an die zu behandelnde Oberfläche angelegten Plasmafadens zur Geschwindigkeit der Bewegung der zu behandelnden Oberfläche relativ zum Plasma ist.

**19.** Verfahren nach einem der Ansprüche 11 bis 18, **dadurch gekennzeichnet, dass** eine Mehrzahl von über die zu behandelnde Oberfläche verteilten, verzweigten Plasmabüscheln gleichzeitig erzeugt und angelegt wird.

**20.** Verfahren nach einem der vorangehenden Ansprüche, **dadurch gekennzeichnet, dass** für aufeinander folgende, unterschiedliche Behandlungen der zu behandelnden Oberfläche das Plasma aufeinanderfolgend durch Behandlungsgase unterschiedlicher Zusammensetzungen gespeist wird.

**21.** Verfahren nach dem vorangehenden Anspruch, **dadurch gekennzeichnet, dass** die Behandlungsgase Argon, organische Dämpfe wie Dämpfe aus Silicium und Sauerstoff sowie Kohlenwasserstoffe umfassen.

**22.** Verfahren nach einem der Ansprüche 2 bis 4 für den Fall der Behandlung von Flaschen oder anderen tiefen Behältern, **dadurch gekennzeichnet, dass** für eine erhöhte Wirksamkeit der Behandlung auf dem Boden gegenüber einem engen Hals Schwingungen unter dem Boden des Behälters erzeugt werden.

**23.** Verfahren nach einem der Ansprüche 2 bis 5, **dadurch gekennzeichnet, dass** durch die Erzeugung von Schwingungen in einer bestimmten Richtung bezüglich der zu behandelnden Oberfläche ein anisotropes Ätzen der zu behandelnden Oberfläche ausgeführt wird.

**24.** Verfahren nach dem vorangehenden Anspruch für den Fall der Ätzbehandlung einer Halbleiteroberfläche, **dadurch gekennzeichnet, dass** Schwingungen erzeugt werden, die sich in einer zu dieser Oberfläche im Wesentlichen senkrechten Richtung verschieben.

**25.** Verfahren nach einem der Ansprüche 1 bis 15, **dadurch gekennzeichnet, dass** die Plasmabehandlung eine Ätzbehandlung ist und dass die Wellenbewegung der zu behandelnden Oberfläche wie z.B. der Oberfläche einer einkristallinen Siliziumscheibe, auf der eine teilweise durch Masken aus Photoresistmaterial geschützte mikroelektronische Struktur aufgebracht worden ist, in einer bestimmten Richtung wie z.B. senkrecht zur Scheibenoberfläche erfolgt, wodurch es ermöglicht wird, eine anisotrope Ätzbehandlung auszuführen, wobei der Grad der Anisotropie von der Amplitude und Frequenz der der zu behandelnden Oberfläche aufgezwungenen Wellenbewegung abhängt.

**26.** Verfahren nach einem der Ansprüche 1 bis 15, **dadurch gekennzeichnet, dass** der zu behandelnde Körper eine Metall- oder Plastikfolie oder ein Tuch aus Textilmaterial ist, die der gleichzeitigen Einwirkung eines Plasmastromes und einer Schwingungsbewegung des Trägers ausgesetzt werden, der die Lage der Folie bzw. des Tuches bezüglich des Plasmastromes festlegt.

**27.** Verfahren nach einem der Ansprüche 1 bis 15, **dadurch gekennzeichnet, dass** das Plasma in der Gestalt verzweigter Plasmafadennetze gleichzeitig durch zwei Hochfrequenzentladungen an zwei Stellen der inneren Oberfläche eines zu behandelnden Körpers von grossem Volumen und komplizierter Konfiguration zwischen zwei kapazitiven Elektroden erzeugt wird, die eine die äussere Oberfläche eines zu behandelnden Körpers überstreichende Bewegung ausführen.

**28.** Verfahren nach einem der vorangehenden Ansprüche, **dadurch gekennzeichnet, dass** die Dichte der dem zu behandelnden Gegenstand durch die Wellenbewegung mitgeteilten Energie höher als ein Promille der Erhöhung der dem Gegenstand vor oder während der Behandlung mitgeteilten thermischen Energiedichte ist.

**29.** Verfahren nach einem der vorangehenden Ansprüche, **dadurch gekennzeichnet, dass** die Dichte der dem zu behandelnden Gegenstand durch die Wellenbewegung mitgeteilten Energie höher als ein Prozent der Erhöhung der dem Gegenstand vor oder während der Behandlung mitgeteilten thermischen Energiedichte ist.

**30.** Verfahren nach einem der vorangehenden Ansprüche, **dadurch gekennzeichnet, dass** die Amplitude der Wellenbewegung merklich grösser als die Dicke der Grenzschicht ist, die sich während der Plasmabehandlung zwischen dem Plasma und der Oberfläche des Gegenstandes aufbaut, wobei dieser Effekt von einer Verwirbelung des Plasmas begleitet wird.

**31.** Vorrichtung für die Umsetzung eines Verfahrens zur Oberflächenbehandlung nach einem der Ansprüche 1 bis 30, **dadurch gekennzeichnet, dass** sie eine Vorrichtung zur Plasmaerzeugung, die in der Lage ist, Plasmaimpulse zu erzeugen, die eine Anstiegszeit ($t_1$) der Amplitude des elektrischen Stromes eines Impulses besitzen, die kleiner als das Verhältnis (d/v) des Durchmessers (d) eines Kanals oder Fadens des erzeugten Plasmas zur Schallgeschwindigkeit (v) in dem den Plasmakanal umgebenden Gasmedium ist, sowie einen Schwingungsfühler umfasst, der so ausgelegt ist, dass er die während des Prozesses der Plasma-Oberflächenbehandlung durch den zu behandelnden Gegenstand ausgesendeten Schwingungen misst.

**32.** Vorrichtung nach Anspruch 31, **dadurch gekennzeichnet, dass** die Vorrichtung zur Plasmaerzeugung in der Lage ist, Plasmaimpulse zu erzeugen, die eine Anstiegszeit ($t_1$) der Amplitude des elektrischen Stromes eines Impulses besitzen, die kleiner oder gleich $3 \times 10^{-6}$ s ist.

**33.** Vorrichtung nach Anspruch 31, **dadurch gekennzeichnet, dass** sie ein Lasersystem umfasst, das durch eine Wand des zu behandelnden Gegenstandes einen Laserstrahl aussenden kann, und einen Fühler für zurückgeworfene oder die Wand querende Laserstrahlen aufweist, um die Menge der beim Durchgang des Laserstrahles durch die behandelte Oberfläche durch nichtlineare Effekte ausgesendeten Photonen oder die Verringerung des Stromes der Primärphotonen auf Grund ihrer Rekombination im Gefolge der nichtlinearen Effekte zu erfassen.

**34.** Vorrichtung nach einem der Ansprüche 31 bis 33, **dadurch gekennzeichnet, dass** sie eine Vorrichtung zur Kühlung des zu behandelnden Gegenstandes durch Ausgiessen oder Aufspritzen eines Fluids auf den zu behandelnden Gegenstand umfasst.

**35.** Vorrichtung nach dem vorangehenden Anspruch, **dadurch gekennzeichnet, dass** die Kühlvorrichtung während oder sofort nach Anlegen des Plasmas an die zu behandelnde Oberfläche Luft oder ein anderes Gas gegen den zu behandelnden Gegenstand bläst.

**36.** Vorrichtung nach einem der Ansprüche 31 bis 35, **dadurch gekennzeichnet, dass** die Vorrichtung zur Plasmaerzeugung eine Elektrode umfasst, die relativ zu dem zu behandelnden Gegenstand verschoben werden kann.

37. Vorrichtung nach einem der Ansprüche 31, 32, 33, 35 oder 36, **dadurch gekennzeichnet, dass** die Vorrichtung zur Plasmaerzeugung eine Elektrode mit einer Gaszufuhrleitung aufweist.

38. Vorrichtung nach dem vorangehenden Anspruch, **dadurch gekennzeichnet, dass** die Elektrode eine Mehrzahl von Gaszufuhrleitungen umfasst.

39. Vorrichtung nach einem der beiden vorangehenden Ansprüche, **dadurch gekennzeichnet, dass** die Elektrode einen drehbaren Gaszufuhrkopf umfasst, auf den der oder die Behandlungsgas-Zufuhrleitungen für die Behandlung von im Wesentlichen axialsymmetrischen Behältern montiert sind.

40. Vorrichtung nach einem der Ansprüche 36 bis 39, **dadurch gekennzeichnet, dass** der Neigungswinkel der Behandlungsgas-Zufuhrleitungen so einstellbar ist, dass der Winkel des Auftreffens des Behandlungsgases auf die zu behandelnde Oberfläche angepasst werden kann.

41. Vorrichtung nach einem der Ansprüche 36 bis 39, **dadurch gekennzeichnet, dass** die Leitungen für die Zufuhr des Behandlungsgases für die Behandlung von im Wesentlichen axialsymmetrischen Behältern für eine im Wesentlichen axialsymmetrische Verteilung des Behandlungsgases im Wesentlichen kegelförmig angeordnet sind.

42. Vorrichtung nach Anspruch 31, **dadurch gekennzeichnet, dass** sie eine Vorrichtung zur Plasmaerzeugung durch elektrische Entladungen aufweist, die eine Elektrode in der Gestalt eines leitenden Flüssigkeitsstrahles umfasst, der gegen eine Wand des zu behandelnden Gegenstandes gegenüber der zu behandelnden Oberfläche gerichtet werden kann.

43. Vorrichtung nach einem der Ansprüche 31 bis 42, **dadurch gekennzeichnet, dass** sie Mittel für die Aufzeichnung und Kontrolle der Plasmaparameter während der Behandlung umfasst.

44. Vorrichtung nach dem vorangehenden Anspruch, **dadurch gekennzeichnet, dass** die Mittel für die Aufzeichnung und Kontrolle der Parameter in der Lage sind, die Anstiegsflanke des elektrischen Spannungs- und/oder Stromimpulses aufzuzeichnen und/oder zu kontrollieren.

45. Vorrichtung nach Anspruch 43 oder 44, **dadurch gekennzeichnet, dass** die Mittel für die Aufzeichnung und Kontrolle der Parameter in der Lage sind, die Amplitude und Dauer der Impulse wie auch die Pause zwischen den Impulsen aufzuzeichnen und/oder zu kontrollieren.

46. Vorrichtung nach Anspruch 43, 44 oder 45, **dadurch gekennzeichnet, dass** die Mittel für die Aufzeichnung und Kontrolle der Parameter in der Lage sind, die Amplitude und Frequenz der durch den zu behandelnden Gegenstand ausgesendeten akustischen Schwingungen aufzuzeichnen und/oder zu kontrollieren.

47. Vorrichtung nach Anspruch 43, 44, 45 oder 46, **dadurch gekennzeichnet, dass** die Mittel für die Aufzeichnung und Kontrolle der Parameter in der Lage sind, die Temperatur des zu behandelnden Gegenstandes aufzuzeichnen und/oder zu kontrollieren.

FIG. 1a

FIG. 1b

28

FIG.2a

FIG.2b

FIG.2c

FIG. 3 a

FIG. 3b

FIG. 3c

*FIG. 4b*          *FIG. 4a*

FIG. 5

EP 1 374 276 B1

FIG. 7

FIG. 6

34

FIG.8

FIG.9

**FIG. 10**

**FIG. 11**

*FIG. 12*

*FIG. 13*

FIG .14

FIG. 15a

FIG. 15b

FIG. 15c

FIG. 16

## RÉFÉRENCES CITÉES DANS LA DESCRIPTION

### Documents brevets cités dans la description

- GB 1098693 A
- WO 9722369 A
- WO 9946964 A
- US 5569502 A
- DE 4128779
- DE 3900798
- JP 08078745 B

### Littérature non-brevet citée dans la description

- **S. KRAPIVINA.** *Procédés plasmochimiques en technologie,* 1981, 27
- **A. KAKLIOUGIN ; P. KOULIK et al.** HF Atmospheric Plasma Sterilization of Dielectric Containers Inside Surfaces. *SFV,* 2001, 28
- **S. BRAUN.** *Basic Processes in Gas Discharges,* 1959, vol. 12